# EUROPEAN PATENT APPLICATION

(11) **EP 4 563 833 A1**
(43) Date of publication of application: **04.06.2025**
(21) Application number: 23922320.9
(22) Date of filing: 07.10.2023
(51) Int. Cl.: F16C 11/04, F16C 11/10

(54) **ROTATING SHAFT MECHANISM AND TERMINAL DEVICE**

(30) Priority: 16.02.2023 CN 202310185102
(71) Applicant: Huawei Technologies Co., Ltd., Shenzhen, Guangdong 518129 (CN)
(72) Inventor: LIN, Yangming, Shenzhen, Guangdong 518129 (CN); ZHENG, Yi, Shenzhen, Guangdong 518129 (CN); XIE, Tingyu, Shenzhen, Guangdong 518129 (CN); XU, Huahua, Shenzhen, Guangdong 518129 (CN)
(74) Representative: Pfenning, Meinig & Partner mbB
(86) International application number: PCT/CN2023/123238
(87) International publication number: WO 2024/169202

(57) **Abstract**

A hinge mechanism (100) and a terminal device are provided. The hinge mechanism (100) includes a base (1), a swing arm assembly (2), an elastic piece (3), and a first cam structure (4). The swing arm assembly (2) includes a bearing member (23), a pair of swing arms (21) that are rotatably connected to edges of two opposite sides of the base (1), and an even number of gears (22), where the even number of gears (22) are in transmission connection between the pair of swing arms (21), and the bearing member (23) is fastened relative to the base (1) in a circumferential direction of the gear (22). The elastic piece (3) is configured to apply an elastic force to at least one of the bearing member (23) and the gear (22). The first cam structure (4) is disposed between a first end face (221) of the gear (22) and the bearing member (23), and includes a first protrusion part (41) disposed on one of the bearing member (23) and the first end face (221), and a second protrusion part (42) disposed on the other of the bearing member (23) and the first end face (221).

## Description

This application claims priority to Chinese Patent Application No. 202310185102.4, filed with the China National Intellectual Property Administration on February 16, 2023 and entitled "HINGE MECHANISM AND TERMINAL DEVICE", which is incorporated herein by reference in its entirety.

### TECHNICAL FIELD

This application relates to the field of terminal device technologies, and in particular, to a hinge mechanism and a terminal device.

### BACKGROUND

With development of technologies, terminal devices change greatly in forms. The terminal devices such as a foldable mobile phone, a foldable tablet computer, and a foldable wearable device gradually become an important development direction of future intelligent terminal devices.

To keep the terminal device in a folded state and avoid unfolding the terminal device in a transportation or carrying process, a designer usually designs a locking structure on the terminal device, so that the terminal device remains in the folded state. The locking structure needs to be unlocked first to unfold the terminal device for use.

To facilitate unfolding of the terminal device after the locking structure is unlocked, a terminal device in a conventional technology is provided with a torsion spring in a hinge mechanism. As the hinge mechanism moves toward a folding position, the torsion spring deforms to store elastic potential energy. After the locking structure is unlocked, the terminal device is ejected at a specific angle under an action of the torsion spring. However, in a process of moving the hinge mechanism toward the folding position, the torsion spring deforms greatly, and a change amplitude of a reaction force exerted on the torsion spring is large. As a result, a service life of the torsion spring is affected to a specific extent. As a quantity of folding and unfolding times of the terminal device increases, elasticity of the torsion spring is weakened, affecting stability of an ejecting angle of a housing of the terminal device.

### SUMMARY

Embodiments of this application provide a hinge mechanism and a terminal device, to resolve a problem in a conventional technology that stability of an ejecting angle of a hinge mechanism is poor after a locking structure of a terminal device is unlocked.

To achieve the foregoing objective, the following technical solutions are used in embodiments of this application.

According to a first aspect, an embodiment of this application provides a hinge mechanism, including a base, a swing arm assembly, an elastic piece, and a first cam structure. The swing arm assembly includes a bearing member, a pair of swing arms that are rotatably connected to edges of two opposite sides of the base, and an even number of gears, where the even number of gears are in transmission connection between the pair of swing arms for each swing arm to be synchronously rotatable relative to the base between a folding position and an unfolding position, the bearing member and the gear are arranged in an axial direction of the gear, and the bearing member is fastened relative to the base in a circumferential direction of the gear. The elastic piece is configured to apply an elastic force to at least one of the bearing member and the gear for the bearing member to be close to the gear. The first cam structure is disposed between a first end face of the gear and the bearing member, and includes a first protrusion part disposed on one of the bearing member and the first end face, and a second protrusion part disposed on the other of the bearing member and the first end face, where the first protrusion part includes a first side surface. When the swing arm is at the folding position, the second protrusion part abuts against the first side surface, and under an action of the elastic force, the second protrusion part and the first side surface move relative to each other or have a trend of moving relative to each other, to apply, to the gear, an action force for driving the swing arm to rotate toward the unfolding position.

According to the hinge mechanism in this embodiment of this application, the elastic piece applies the elastic force to at least one of the bearing member and the gear, so that the bearing member approaches the gear, to ensure that the second protrusion part can abut against the first side surface. In this way, in a process in which the swing arm rotates from the folding position to the unfolding position, a deformation amplitude of the elastic piece is determined by relative displacements of the first protrusion part and the second protrusion part in the axial direction of the gear, that is, the deformation amplitude of the elastic piece is determined by a height of the first protrusion part. Because the height of the first protrusion part is smaller than a rotation displacement of the swing arm relative to the base, a problem that the deformation amplitude of the elastic piece is large can be avoided, and a reaction force on the elastic piece can be reduced. This helps prolong a life of the elastic piece, and ensures stability of an ejecting angle of housings of the terminal device. In addition, according to the hinge mechanism in this embodiment of this application, an action force generated by the first cam structure when the swing arm is at the folding position may be synchronously transferred to the pair of swing arms in the swing arm assembly through the even number of gears. In this way, an ejection force on the pair of swing arms is the same, so that stability of the pair of swing arms in an ejection process can be improved, and the pair of swing arms can be elastically ejected at a same angle.

In some embodiments, there are a plurality of first protrusion parts, the plurality of first protrusion parts are arranged in the circumferential direction of the gear, a first notch is formed between two adjacent first protrusion parts, and when the swing arm is at the folding position and the unfolding position, the second protrusion part extends into a same first notch. In this way, the deformation amplitude of the elastic piece can be smaller, to further prolong the service life of the elastic piece.

In some embodiments, a first bottom surface is disposed in the first notch, the first bottom surface is perpendicular to the axial direction of the gear, and when the swing arm is at the unfolding position, the second protrusion part abuts against the first bottom surface. In this way, stability of relative positions between the second protrusion part and the first protrusion part can be ensured, so that stability of the terminal device in an unfolded state can be ensured.

In some embodiments, the first protrusion part includes a second side surface, in the circumferential direction of the gear, the second side surface is disposed opposite to the first side surface, an inclination angle of the second side surface relative to the axial direction of the gear is less than an inclination angle of the first side surface relative to the axial direction of the gear, and the second side surface is connected to a first side surface of an adjacent first protrusion part through the first bottom surface. In this way, abrasion of the first protrusion part in a motion process can be reduced, and a service life of a product can be prolonged.

In some embodiments, when the swing arm is at the folding position, the second protrusion part is in surface contact with the first side surface. In this way, a probability of damage between the first protrusion part and the second protrusion part is reduced.

In some embodiments, when the swing arm is at the unfolding position, the second protrusion part is in surface contact with the first bottom surface. In this way, shake of the swing arm at the unfolding position can be reduced.

In some embodiments, there are a plurality of first protrusion parts, and the plurality of first protrusion parts are arranged in the circumferential direction of the gear; and when the swing arm is at the folding position, the second protrusion part abuts against a first side surface of one first protrusion part; or when the swing arm is at the unfolding position, the second protrusion part abuts against a first side surface of another first protrusion part. In this way, the terminal device can have dual functions of self-ejecting in a folded state and keeping a stable unfolded state through the first cam structure, so that a layout of the cam structure is more compact.

In some embodiments, the first protrusion part includes a second side surface, in the circumferential direction of the gear, the second side surface is disposed opposite to the first side surface, and an inclination angle of the second side surface relative to the axial direction of the gear is greater than an inclination angle of the first side surface relative to the axial direction of the gear. In this way, resistance of the second protrusion part in a case in which the second protrusion part "climbs" along the second side surface is reduced, so that the swing arm can smoothly rotate from the folding position to the unfolding position.

In some embodiments, in the circumferential direction of the gear, a center angle corresponding to a distance between first side surfaces of two adjacent first protrusion parts is 90 degrees. In this way, a quantity of first protrusion parts crossed by the second protrusion parts can be reduced, to reduce the rotation resistance of the swing arm.

In some embodiments, in the swing arm assembly, the first cam structure is disposed between each gear and the bearing member. In this way, a larger torque may be generated to drive the swing arm to rotate toward the unfolding position.

In some embodiments, two outermost gears are fastened to corresponding swing arms, a gear other than the two outermost gears is slidably connected to the base in the axial direction of the gear, and the first cam structure is disposed between the gear and the bearing member. In this way, the swing arm can be more stable in a process of rotating relative to the base.

In some embodiments, in the swing arm assembly, bearing members are respectively disposed on two sides of the gear, the gear has two first end faces disposed opposite to each other, and the first cam structure is disposed between each first end face and a bearing member on a corresponding side. In this way, when the swing arm is at the folding position, first cam structures on the two sides of the gear may generate a larger ejection force, so that the hinge mechanism can be adapted to a terminal device that needs a large torque to eject.

In some embodiments, the hinge mechanism further includes a second cam structure disposed between a second end face of the gear and the bearing member, where the second cam structure includes a third protrusion part disposed on one of the bearing member and the second end face and a fourth protrusion part disposed on the other of the bearing member and the second end face, where the third protrusion part includes a third side surface. When the swing arm is at the unfolding position, the fourth protrusion part abuts against the third side surface, and under the action of the elastic force of the elastic piece, the fourth protrusion part and the third side surface have a trend of moving relative to each other, to apply, to the gear, an action force for preventing the swing arm from rotating in a direction close to the folding position. In this way, the terminal device can be stably kept in the unfolded state.

In some embodiments, the third protrusion part includes a fourth side surface, in the circumferential direction of the gear, the fourth side surface is disposed opposite to the third side surface, and an inclination angle of the fourth side surface relative to the axial direction of the gear is greater than an inclination angle of the third side surface relative to the axial direction of the gear. In this way, resistance of the fourth protrusion part in a case in which the fourth protrusion part "climbs" along the fourth side surface is reduced, so that the swing arm can smoothly rotate from the folding position to the unfolding position.

In some embodiments, there are a plurality of third protrusion parts, the plurality of third protrusion parts are arranged in the circumferential direction of the gear, a second notch is formed between two adjacent third protrusion parts, a first positioning part is disposed in the second notch, and when the swing arm is at the folding position, the first positioning part positions the fourth protrusion part. In this way, shake of the swing arm at the folding position can be reduced, so that stability of the terminal device in the folded state can be ensured.

In some embodiments, the first positioning part includes a first positioning surface perpendicular to the axial direction of the gear, and when the swing arm is at the folding position, the fourth protrusion part is in surface contact with the first positioning surface. This helps reduce processing difficulty, thereby helping reduce processing costs.

In some embodiments, in the swing arm assembly, bearing members are respectively disposed on two sides of the gear, the first end face and the second end face are respectively two end faces disposed opposite to each other of the gear, the first cam structure is disposed between the first end face and a bearing member on a corresponding side, and the second cam structure is disposed between the second end face and a bearing member on a corresponding side. In this way, the terminal device can implement dual functions of self-ejecting in the folded state and keeping a stable unfolded state through a same swing arm assembly.

In some embodiments, there are a plurality of swing arm assemblies, the plurality of swing arm assemblies are arranged in the axial direction of the gear, in a part of the swing arm assemblies, bearing members are respectively disposed on two sides of the gear, the gear has two second end faces disposed opposite to each other, and the second cam structure is disposed between each second end face and a bearing member on a corresponding side; and in the other part of the swing arm assemblies, bearing members are respectively disposed on two sides of the gear, the gear has two first end faces disposed opposite to each other, and the first cam structure is disposed between each first end face and a bearing member on a corresponding side. In this way, positive and negative directions of the gear do not need to be confirmed during assembling, so that the gear is conveniently assembled.

In some embodiments, in the swing arm assembly, the second cam structure is disposed between each gear and the bearing member. In this way, a large unfolding force can be generated to prevent the swing arm from rotating toward the folding position, so that the terminal device can be more stable in the unfolded state.

In some embodiments, two outermost gears are fastened to corresponding swing arms, a gear other than the two outermost gears is slidably connected to the base in the axial direction of the gear, and the second cam structure is disposed between the gear and the bearing member. In this way, the swing arm can be more stable in a process of rotating relative to the base.

In some embodiments, the hinge mechanism further includes a damping mechanism. The damping mechanism includes a first friction member and a second friction member. The first friction member is rotatably connected to the base, and the first friction member is connected to the swing arm via a connector for the first friction member and the swing arm to be synchronously rotatable relative to the base. The second friction member is disposed on the base, and is in contact with the first friction member. When the swing arm rotates between the folding position and the unfolding position, the second friction member is capable of rubbing against the first friction member, to apply a rotation damping force to the swing arm. In this way, when one of the first friction member and the second friction member is damaged, the first friction member or the second friction member can be replaced, so that the entire damping mechanism does not need to be replaced.

In some embodiments, there are a plurality of first friction members and a plurality of second friction members, the plurality of first friction members and the plurality of second friction members are arranged in the axial direction of the gear, a first gap is formed between two adjacent second friction members, and each first friction member is inserted into a corresponding first gap and is in contact with an adjacent second friction member. In this way, an amplitude of the rotation damping force can be conveniently adjusted by adjusting a friction force between the first friction member and the second friction member.

In some embodiments, the first friction member includes an elastic part, a flat hole is provided on the elastic part, and a hole wall of the flat hole has a first flat surface in a circumferential direction of the flat hole. The second friction member is a flat shaft disposed on the base, the flat shaft is fastened relative to the base in a circumferential direction of the flat shaft, the flat shaft has a second flat surface and a third flat surface that are spaced from each other, and the flat shaft penetrates the flat hole. When the swing arm is at the folding position, the first flat surface is disposed opposite to the second flat surface; and when the swing arm is at the unfolding position, the first flat surface is disposed opposite to the third flat surface. In this way, the swing arm can be stably kept at the folding position and the unfolding position, so that stability of the terminal device in the folded state and the unfolded state can be ensured.

In some embodiments, when the swing arm is at the folding position, a second gap is provided between the first flat surface and the second flat surface. In this way, when the swing arm rotates to a position near the folding position, no friction is generated between the first friction member and the second friction member, so that the first cam structure can easily eject the housing of the terminal device.

In some embodiments, when the swing arm is at the unfolding position, a third gap is provided between the first flat surface and the third flat surface. In this way, when the swing arm rotates to a position near the folding position, no friction is generated between the first friction member and the second friction member, so that the second cam structure can keep the terminal device in the unfolded state.

In some embodiments, the elastic part is formed by the first friction member through an edge rolling process. This not only helps improve assembling efficiency of the damping mechanism, but also improves reliability of a connection between the elastic part and a body of the first friction member.

In some embodiments, the first friction member is a sheet-like structure, there are a plurality of first friction members, the plurality of first friction members are stacked, each first friction member is provided with a notch at the flat hole for breaking the hole wall of the flat hole, and the notches of the plurality of first friction members form a slot extending in an axial direction of the flat shaft. This helps reduce processing difficulty and costs of the flat hole of the elastic part.

In some embodiments, the swing arm is rotatably connected to the base through a rotating shaft, a torsion spring is sleeved on the rotating shaft, and a first connection arm of the torsion spring is connected to the swing arm. A stop part is disposed on the base, and when the swing arm is at the unfolding position, a second connection arm is separated from the stop part for the torsion spring to be in a natural state. When the swing arm rotates between a middle position and the folding position, the second connection arm of the torsion spring abuts against the stop part for the torsion spring to be in a force storage state, to apply, to the swing arm, the action force for driving the swing arm to rotate toward the unfolding position, where the middle position is a position between the folding position and the unfolding position in a rotation direction of the swing arm. In this way, a magnitude of a reaction force, to which the torsion spring is applied, of the swing arm and the stop part can be reduced, so that the service life of the torsion spring can be prolonged.

In some embodiments, an arc-shaped groove for the second connection arm to extend into is provided on the base, the arc-shaped groove extends in a circumferential direction of the rotating shaft, and a groove wall at an end of the arc-shaped groove is the stop part. In this way, the stop part has a simple structure, thereby helping reducing costs. In addition, shake of the second connection arm in a motion process may be further reduced, so that the second connection arm moves more stably.

In some embodiments, the stop part is a stop surface disposed on the base, and motion space for the second connection arm to swing is provided between the stop surface and the torsion spring. In this way, the stop part has a simple structure, thereby helping reducing costs.

According to a second aspect, an embodiment of this application provides a terminal device, including a display, at least two housings, and the hinge mechanism according to the first aspect, where the housing is configured to carry the display, the hinge mechanism is at a joint of two adjacent housings, and each swing arm of the swing arm assembly in the hinge mechanism is connected to a corresponding housing.

A technical effect achieved by the terminal device is the same as that achieved by the hinge mechanism in the first aspect. Details are not described herein again.

### BRIEF DESCRIPTION OF DRAWINGS

FIG. 1 is a diagram of a structure of a hinge mechanism of a terminal device (a notebook computer) in a conventional technology;
FIG. 2 is a diagram of a structure of a terminal device (a mobile phone) in an unfolded state according to some embodiments of this application;
FIG. 3 is a diagram of a structure of the terminal device in FIG. 2 after removal of a display;
FIG. 4 is a diagram of a structure of the terminal device in FIG. 2 in a folded state;
FIG. 5 is a partially enlarged view of the terminal device in FIG. 3 at A;
FIG. 6 is a diagram of a structure of a hinge mechanism according to a first embodiment of this application;
FIG. 7 is a sectional view of the hinge mechanism in FIG. 6 at M-M;
FIG. 8 is a diagram of a swing arm of the hinge mechanism in FIG. 7 at a folding position;
FIG. 9 is an exploded view of the hinge mechanism in FIG. 6;
FIG. 10 is a B-direction view of the hinge mechanism in FIG. 7;
FIG. 11 is a three-dimensional diagram of a swing arm of the hinge mechanism at a folding position according to the first embodiment of this application;
FIG. 12 is a partially enlarged view of the hinge mechanism in FIG. 11 at C;
FIG. 13 is a three-dimensional diagram of the swing arm of the hinge mechanism at an unfolding position according to the first embodiment of this application;
FIG. 14 is a partially enlarged view of the hinge mechanism in FIG. 13 at D;
FIG. 15 is a circumferentially expanded view of a first cam structure between each of four gears of a swing arm assembly and a bearing member in a case in which the swing arm is at different positions according to the first embodiment of this application;
FIG. 16 is a circumferentially expanded view of a first cam structure between a rightmost gear and the bearing member in FIG. 15 in a case in which a swing arm is at different positions;
FIG. 17 is a diagram of a first cam structure disposed on a gear connected to the swing arm of the hinge mechanism according to the first embodiment of this application;
FIG. 18 is a diagram of a structure of a first cam structure disposed on a bearing member in the hinge mechanism according to the first embodiment of this application;
FIG. 19 is a circumferentially expanded view of a second cam structure between each of the four gears of the swing arm assembly and the bearing member in the case in which the swing arm is at the different positions according to the first embodiment of this application;
FIG. 20 is a circumferentially expanded view of a second cam structure between a rightmost gear and the bearing member in FIG. 19 in a case in which a swing arm is at different positions;
FIG. 21 is a diagram of a second cam structure disposed on a gear connected to the swing arm of the hinge mechanism according to the first embodiment of this application;
FIG. 22 is a diagram of a second cam structure disposed on the bearing member in the hinge mechanism according to the first embodiment of this application;
FIG. 23 is a diagram of another structure of a second cam structure according to an embodiment of this application;
FIG. 24 is a diagram of a swing arm of a hinge mechanism at an unfolding position according to a second embodiment of this application;
FIG. 25 is a diagram of a swing arm of a hinge mechanism at an unfolding position according to a third embodiment of this application;
FIG. 26 is a three-dimensional diagram of the swing arm of the hinge mechanism at a folding position according to the third embodiment of this application;
FIG. 27 is a partially enlarged view of the hinge mechanism in FIG. 26 at E;
FIG. 28 is a three-dimensional diagram of the swing arm of the hinge mechanism at the unfolding position according to the third embodiment of this application;
FIG. 29 is a partially enlarged view of the hinge mechanism in FIG. 28 at F;
FIG. 30 is a circumferentially expanded view of a first cam structure between each of four gears of a swing arm assembly and a bearing member in a case in which the swing arm is at different positions according to the third embodiment of this application;
FIG. 31 is a circumferentially expanded view of a first cam structure between a rightmost gear and the bearing member in FIG. 30 in a case in which a swing arm is at different positions;
FIG. 32 is a diagram of a structure of a first cam structure disposed on the bearing member in the hinge mechanism according to the third embodiment of this application;
FIG. 33 is an exploded view of a damping mechanism of the hinge mechanism shown in FIG. 28;
FIG. 34 is a sectional view of a first friction member after removal of a connection frame from the hinge mechanism shown in FIG. 28;
FIG. 35 is a sectional view of a first friction member after removal of a connection frame from the hinge mechanism shown in FIG. 26;
FIG. 36 is diagram of another structure of a damping mechanism in a hinge mechanism according to an embodiment of this application;
FIG. 37 is a diagram of a position relationship between a first friction member and a second friction member in a rotation process in FIG. 36;
FIG. 38 is a partially enlarged view of a joint between the first friction member and the second friction member in FIG. 37;
FIG. 39 is diagram of a third structure of a damping mechanism in a hinge mechanism according to an embodiment of this application;
FIG. 40 is a diagram of a structure of a hinge mechanism according to some embodiments of this application;
FIG. 41 is a partially enlarged view of a position of a torsion spring in the hinge mechanism shown in FIG. 40;
FIG. 42 is a sectional view of the hinge mechanism in FIG. 40 at H-H;
FIG. 43 is a status diagram of a torsion spring in a rotation process of a swing arm according to an embodiment of this application;
FIG. 44 is a sectional view of a base of a hinge mechanism at a position close to a torsion spring according to some embodiments of this application; and
FIG. 45 is a position status diagram of a second connection arm of a torsion spring in a rotation process of a swing arm according to an embodiment of this application.

### DESCRIPTION OF EMBODIMENTS

The terms "first" and "second" in embodiments of this application are merely intended for a purpose of description, and shall not be understood as an indication or implication of relative importance or implicit indication of a quantity of indicated technical features. Therefore, a feature limited by "first" or "second" may explicitly or implicitly include one or more features.

With development of technologies, terminal devices change greatly in forms. The terminal devices such as a foldable mobile phone, a foldable tablet computer, and a foldable wearable device gradually become an important development direction of future intelligent terminal devices.

When the terminal device does not work, the terminal device is folded to be carried conveniently. To keep the terminal device in a folded state and avoid unfolding the terminal device in a transportation or carrying process, a designer usually designs a locking structure (for example, a buckle or a magnetic attraction member) on the terminal device, so that the terminal device remains in the folded state. The locking structure needs to be unlocked first to unfold the terminal device for use.

Currently, in some terminal devices, an auxiliary unfolding structure like a buckle slot or a buckle slope is disposed on a housing, to facilitate unfolding of the terminal device after the locking structure is unlocked, so that a user unfolds the terminal device through the auxiliary unfolding structure. However, adding the auxiliary unfolding structure not only affects an appearance of the terminal device, but also occupies much space on the housing. Especially for a foldable mobile phone, generally, there is no sufficient space on the housing for design. This increases difficulty in designing the auxiliary unfolding structure.

To resolve a problem that much space is occupied for deposing the auxiliary unfolding structure on the housing, currently, in some other terminal devices, the auxiliary unfolding structure is disposed in a hinge mechanism (also referred to as a hinge mechanism) of the terminal device. In this way, after the locking structure of the terminal device is unlocked, the terminal device automatically ejects to a specific angle through the auxiliary unfolding structure, to facilitate a subsequent unfolding operation of a user.

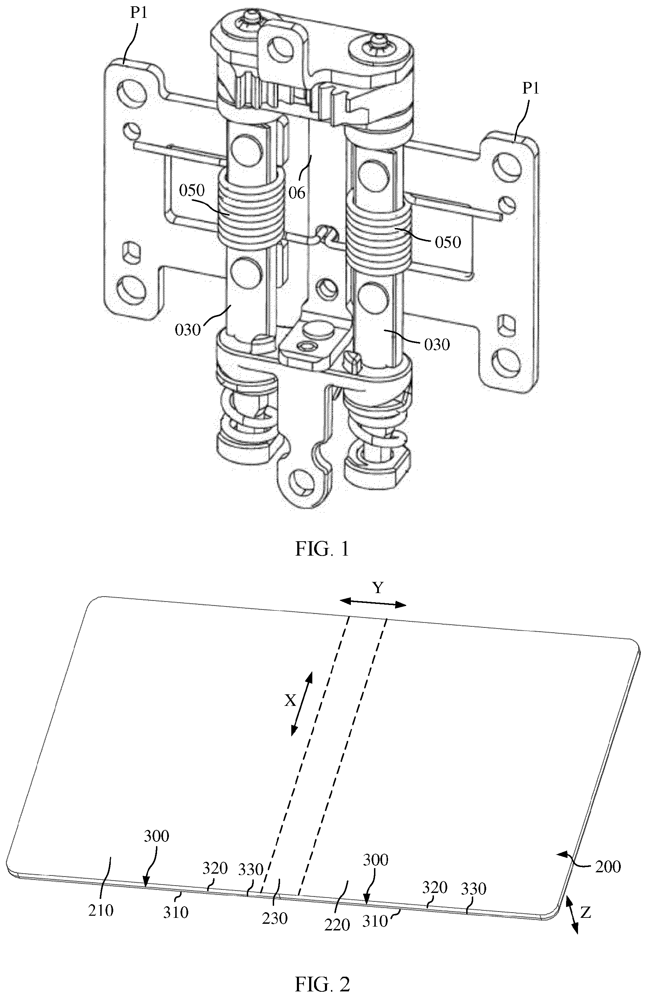

As shown in FIG. 1, FIG. 1 is a diagram of a structure of a hinge mechanism of a terminal device (a notebook computer) in a conventional technology. The hinge mechanism includes a base 06, main pin shafts 030, a pair of fastening pieces P1, and torsion springs 050. The fastening pieces P1 are configured to be fastened to housings of the terminal device. Each fastening piece P1 is rotatably connected to the base 06 through the main pin shaft 030, and the torsion spring 050 is sleeved on the main pin shaft 030. A fixed end of the torsion spring 050 is inserted into an opening of the base 06, and a force-applying end of the torsion spring 050 separately abuts against the fastening piece P1.

When the fastening piece P1 rotates along with the main pin shaft 030 toward a folding position, the force-applying end of the torsion spring 050 is driven to rotate, so that the torsion spring 050 deforms. After the housings connected to the two fastening pieces P1 are folded, the torsion spring 050 deforms to the maximum, and stores elastic potential energy. Therefore, after the locking structure is unlocked, the housings connected to the two fastening pieces P1 are ejected to a specific angle under an action of the torsion spring 050.

In the hinge mechanism in the conventional technology, the housing of the terminal device is controlled to be ejected only by an elastic force of the torsion spring 050. However, in a process in which the fastening piece P1 rotates from an unfolding position to the folding position, the force-applying end of the torsion spring 050 rotates together with the fastening piece P1 until the folding position. In this way, a deformation amplitude of the torsion spring 050 is large, and a change amplitude of a reaction force of the torsion spring 050 is large. As a result, a service life of the torsion spring 050 is affected to a specific extent. As a quantity of folding and unfolding times of the terminal device increases, elasticity of the torsion spring 050 is weakened, an elastic force applied to the fastening piece P1 is reduced, and an angle of ejecting the housing of the terminal device is reduced, affecting stability of the angle of ejecting the housing of the terminal device.

In view of this, embodiments of this application provide a hinge mechanism and a terminal device. A cam structure is disposed in the hinge mechanism, so that the cam structure can provide an ejection force when the terminal device is in a folded state, to resolve a problem in a conventional technology that the hinge mechanism has poor ejecting angle stability after a locking structure of the terminal device is unlocked.

The terminal device in embodiments of this application may be a foldable terminal device like a mobile phone, a tablet computer, a notebook computer, or a wearable device. The following uses a mobile phone as an example to describe a specific structure of the hinge mechanism in the terminal device. For another terminal device, specifically, refer to the hinge mechanism in the mobile phone embodiment. Details are not described herein again.

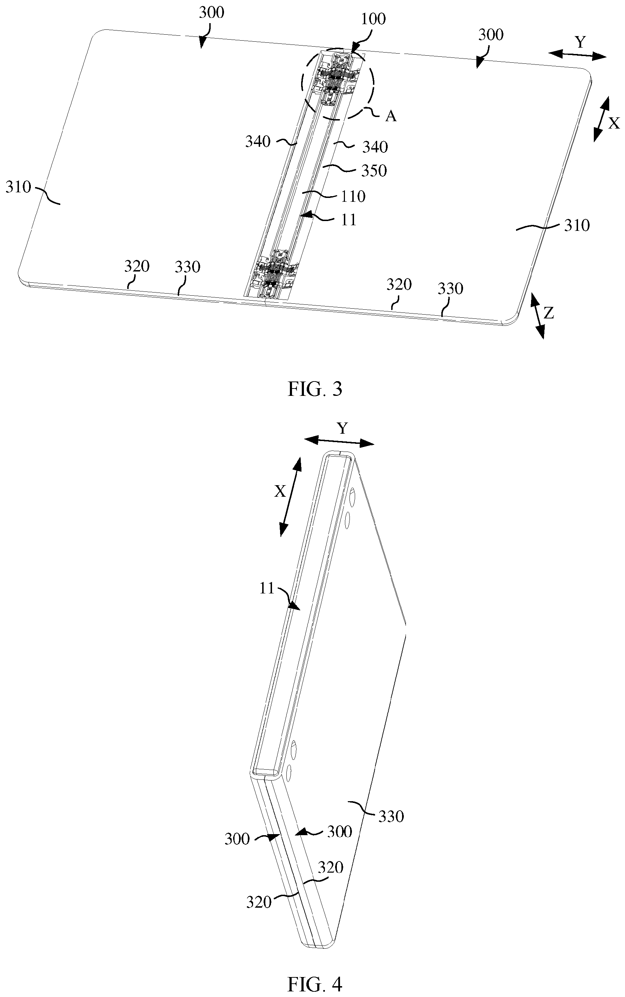

As shown in FIG. 2, FIG. 3, and FIG. 4, FIG. 2 is a diagram of a structure of a terminal device (a mobile phone) in an unfolded state according to some embodiments of this application; FIG. 3 is a diagram of a structure of the terminal device in FIG. 2 after removal of a display 200; and FIG. 4 is a diagram of a structure of the terminal device in FIG. 2 in a folded state.

The terminal device includes a hinge mechanism 100, a display 200, and two housings 300. The housings 300 are configured to carry the display 200. The hinge mechanism 100 is disposed at a joint of the two housings 300, so that the two housings 300 may switch between the unfolded state (as shown in FIG. 2) and the folded state (as shown in FIG. 4).

Certainly, the terminal device is not limited to being provided with two housings 300, and may alternatively be provided with more than two housings 300, for example, three or four housings 300, which may be specifically determined based on an actual situation. The hinge mechanism 100 is disposed at a joint of two adjacent housings 300.

As shown in FIG. 2 and FIG. 3, the housing 300 includes a housing bottom wall 310, a housing side wall 320 disposed at an edge of the housing bottom wall 310, and a rear cover 330 (also referred to as a battery cover) fastened on the housing side wall 320. The housing bottom wall 310, the housing side wall 320, and the rear cover 330 jointly enclose disposing space, and components such as a battery and a circuit board are disposed in the disposing space. A display 200 is disposed on a side that is of the housing bottom wall 310 and that is away from the disposing space.

In some embodiments, as shown in FIG. 2 and FIG. 3, the display 200 may be disposed on a surface that is of the housing bottom wall 310 and that is away from the disposing space. In some other embodiments, a first accommodating groove is provided on a surface that is of the housing bottom wall 310 and that is away from the disposing space, and the display 200 is disposed in the first accommodating groove provided on the housing bottom wall 310.

The display 200 has a bendable performance, and may be bent and deformed after being applied with an external force. As shown in FIG. 3, when the two housings 300 are in the unfolded state, the display 200 is unfolded, and a display area of the display 200 is exposed to display image information to a user. The display 200 includes a first display area 210, a second display area 220, and a third display area 230. The first display area 210 covers the housing bottom wall 310 of one housing 300, the second display area 220 covers the housing bottom wall 310 of the other housing 300, and the third display area 230 covers the hinge mechanism 100.

The entire display 200 may be of a flexible display structure. For example, the first display area 210, the second display area 220, and the third display area 230 of the display 200 are all of a flexible display structure. Alternatively, the display 200 may be of a flexible display structure in the middle foldable part, and a hard display structure on two sides. For example, the first display area 210 and the second display area 220 of the display 200 are of a hard display structure, and the third display area 230 is of a flexible display structure.

As shown in FIG. 4, when the two housings 300 are in the folded state, the two housings 300 are stacked. In this case, the display 200 is folded between the two housings 300. Therefore, the terminal device can be conveniently carried. The first display area 210 and the second display area 220 of the display 200 are stacked. The "stacked" herein means that the first display area 210 and the second display area 220 are stacked in a thickness direction, and the thickness directions of the first display area 210 and the second display area 220 are parallel or roughly parallel (for example, a deviation is within 10°). The first display area 210 and the second display area 220 that are stacked may be attached together, or there may be a gap between the first display area 210 and the second display area 220. This is not specifically limited herein.

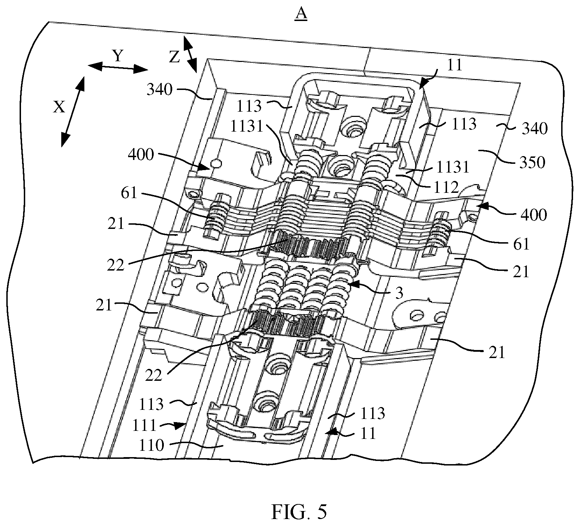

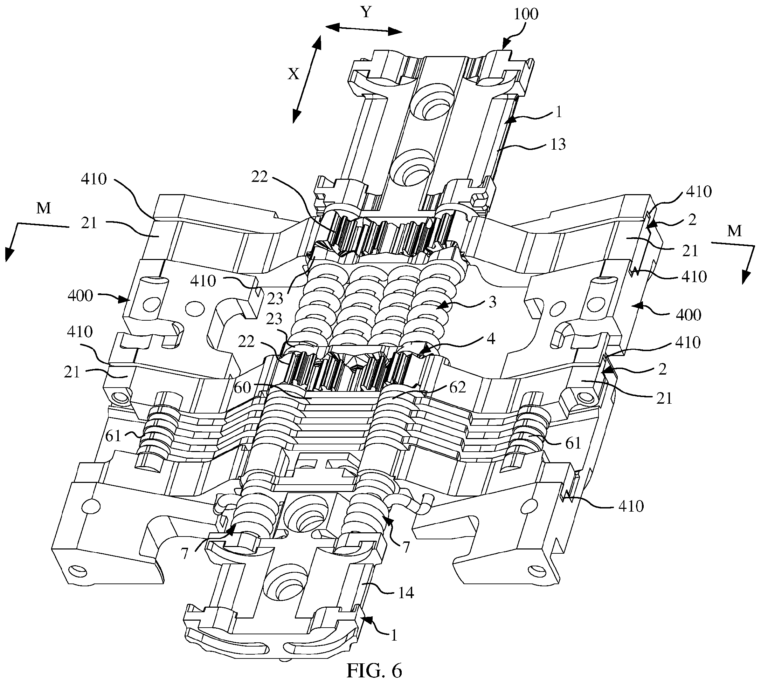

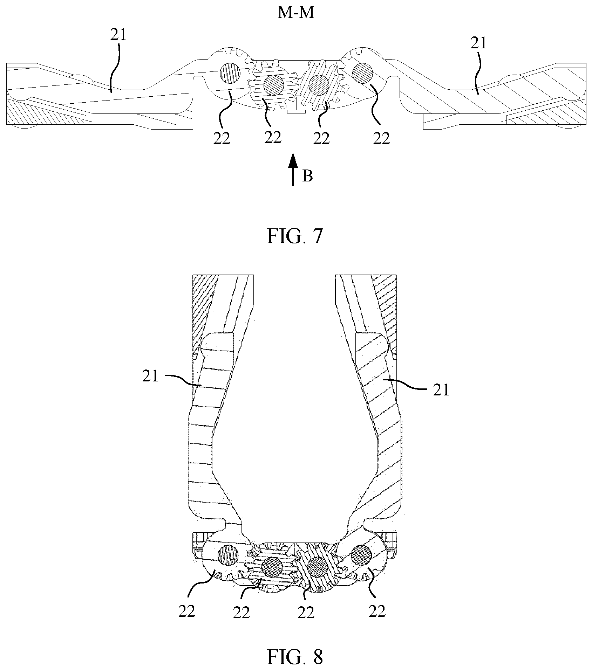

As shown in FIG. 5 to FIG. 8, FIG. 5 is a partially enlarged view of the terminal device in FIG. 3 at A; FIG. 6 is a diagram of a structure of the hinge mechanism 100 according to a first embodiment of this application; FIG. 7 is a sectional view of the hinge mechanism 100 in FIG. 6 at M-M; and FIG. 8 is a diagram of a swing arm of the hinge mechanism 100 in FIG. 7 at a folding position.

The hinge mechanism 100 includes a base 1, a swing arm assembly 2, an elastic piece 3, and a first cam structure 4.

The swing arm assembly 2 includes a pair of swing arms 21 that are rotatably connected to edges of two opposite sides of the base 1, and an even number of gears 22. The even number of gears 22 are in transmission connection between the pair of swing arms 21, so that each swing arm 21 can rotate synchronously relative to the base 1 between a folding position (as shown in FIG. 8) and an unfolding position (as shown in FIG. 7).

When the two housings 300 are in an unfolded state, the pair of swing arms 21 in the swing arm assembly 2 are both at the unfolding position. When the two housings 300 are in a folded state, the two swing arms 21 are both at the folding position. When the two housings 300 are switched to the folded state, the swing arms 21 correspondingly rotate toward the folding position relative to the base 1. When the two housings 300 are switched to the unfolded state, the swing arms 21 correspondingly rotate toward the unfolding position relative to the base 1.

In some embodiments, as shown in FIG. 7 and FIG. 8, in the swing arm assembly 2, there are four gears 22, the four gears 22 are rotatably connected to the base 1, and two adjacent gears 22 are engaged with each other. Two outermost gears 22 are respectively fastened to the corresponding swing arms 21, so that the swing arms 21 can rotate relative to the base 1 on the folding position and the unfolding position.

The four gears 22 are in transmission connection between the pair of swing arms 21. In this way, when one of the swing arms 21 rotates at a specific angle relative to the base 1, the swing arm 21 may transfer power to the other swing arm 21 through the four gears 22, so that the other swing arm 21 also rotates at a same angle relative to the base 1, thereby implementing synchronous rotation of the pair of swing arms 21 in the swing arm assembly 2 relative to the base 1.

A quantity of gears 22 in the swing arm assembly 2 is not limited to four, and may alternatively be two, six, eight, or the like, which may be specifically determined based on an actual situation. When there are two gears 22, each gear 22 is fastened to a corresponding swing arm 21. The gear 22 fastened to the swing arm 21 may be of an integrated structure (as shown in FIG. 7 and FIG. 8) with the swing arm 21, or may be disposed separately from the swing arm 21, which may be specifically determined based on an actual situation.

The even number of gears 22 in the swing arm assembly 2 may be all incomplete gears 22, or may be all complete gears 22, or may be a combination of incomplete gears 22 and complete gears 22. This is not specifically limited herein. For example, as shown in FIG. 8, in the four gears 22, two outermost gears 22 are incomplete gears 22, and two gears 22 located in the middle are complete gears 22.

The incomplete gear 22 means that teeth and tooth grooves are distributed on a part of a circumferential surface of the gear 22 in a circumferential direction. The complete gear 22 means that teeth and tooth grooves are distributed on the entire circumferential surface of the gear 22 in the circumferential direction.

In some embodiments, as shown in FIG. 5 and FIG. 6, the swing arm 21 is connected to a corresponding housing 300 through a connection frame 400, the connection frame 400 is fastened to the housing 300, and the swing arm 21 is slidably connected to the connection frame 400. The swing arm 21 and the connection frame 400 are slidably connected, so that a degree of freedom of a mechanism formed by the housing 300, the base 1, and the swing arm 21 is 1, to ensure that the two housings 300 can be smoothly unfolded and folded.

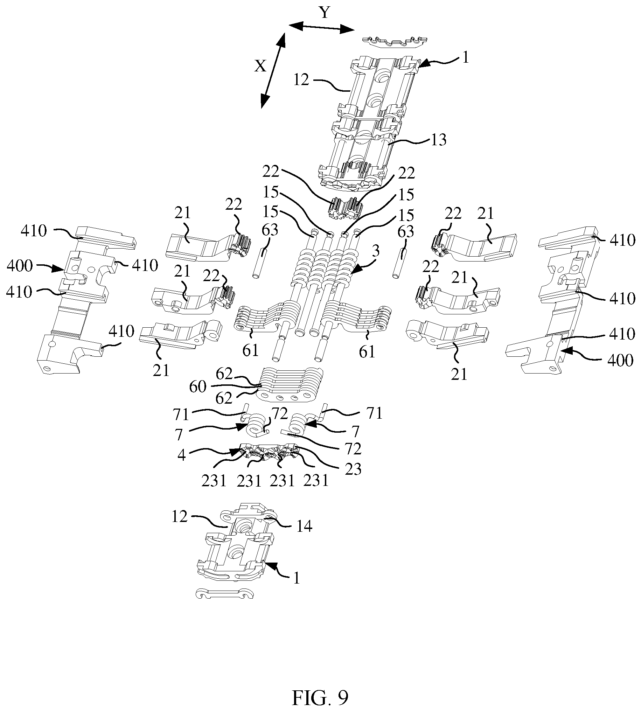

The swing arm 21 and the connection frame 400 may be slidably connected through the following structure: In some embodiments, as shown in FIG. 6 and FIG. 9, a sliding groove 410 is provided on the connection frame 400, one end of the sliding groove 410 is disposed close to the base 1, the other opposite end of the sliding groove 410 is disposed away from the base 1, and the swing arm 21 slidably fits the sliding groove 410. In some other embodiments, a sliding shaft may also be disposed on the swing arm 21, a sliding hole is provided on the connection frame 400, one end of the sliding hole is provided close to the base 1, the other opposite end of the sliding hole is provided away from the base 1, and the sliding shaft slidably fits the sliding hole.

Certainly, the swing arm 21 may be connected to the housing 300 through the connection frame 400 or may be slidably connected to the housing 300 directly. This may be specifically determined based on an actual situation.

In some embodiments, as shown in FIG. 5, FIG. 6, and FIG. 9, FIG. 9 is an exploded view of the hinge mechanism 100 in FIG. 6. The base 1 includes a shaft cover 11, and a base body 12 disposed on the shaft cover 11. The base body 12 includes a first sub-base 13 and a second sub-base 14 that are spaced from each other, and a plurality of mounting shafts 15 disposed between the first sub-base 13 and the second sub-base 14. The plurality of mounting shafts 15 are arranged in a width direction Y of the base 1, and each mounting shaft 15 extends in a length direction X of the base 1. One end of the mounting shaft 15 is connected to the first sub-base 13, and the other end of the mounting shaft 15 is connected to the second sub-base 14. The swing arm assembly 2 is disposed between the first sub-base 13 and the second sub-base 14, and the gear 22 in the swing arm assembly 2 is rotatably sleeved on a corresponding mounting shaft 15, to implement a rotatable connection between the gear 22 and the base 1.

The length direction X of the base 1 is perpendicular to the width direction Y of the base 1, and a thickness direction Z of the terminal device in the unfolded state. An axial direction X of the gear 22 in the swing arm assembly 2 is parallel to the length direction X of the base 1.

The base body 12 in this embodiment of this application is not limited to the structure including the sub-base 1 and the mounting shaft 15. The base body 12 may alternatively be designed into a long-bar structure, and both the swing arm 21 and the gear 22 are rotatably connected to the base body 12 of the long-bar structure.

In some embodiments, as shown in FIG. 3 and FIG. 5, two pairs of first sub-bases 13 and two pairs of second sub-bases 14 are respectively disposed, the two pairs of first sub-bases 13 and the two pairs of second sub-bases 14 are symmetrically distributed on two sides of a middle surface of the base 1 in the length direction X of the base 1, and the swing arm assembly 2 is disposed between each pair of first sub-bases 13 and each pair of second sub-bases 14. In this design, the swing arm assemblies 2 between the two pairs of first sub-bases 13 and the two pairs of second sub-bases 14 may be respectively located on two sides of the middle surface, so that the housing 300 of the terminal device is stressed in a balance manner in the length direction X of the base 1, and the housing 300 of the terminal device is more stable in a process of switching between the folded state and the unfolded state.

In some embodiments, as shown in FIG. 3 and FIG. 5, the shaft cover 11 has accommodating space 110, the base body 12 is disposed in the accommodating space 110, and the base body 12 is fastened to the shaft cover 11. For example, the base body 12 may be fastened to the shaft cover 11 through a fastener like a screw.

As an appearance part (namely, an externally visible part) of the hinge mechanism 100, the shaft cover 11 is configured to cover moving parts such as the swing arm 21 and the gear 22 in the hinge mechanism 100, to avoid external interference to motion of the moving parts in the hinge mechanism 100.

As shown in FIG. 3 and FIG. 5, shielding parts 340 are disposed at a joint of the two housings 300, and the shielding parts 340 are step-shaped. As shown in FIG. 3 and FIG. 5, when the two housings 300 are in the unfolded state, the shaft cover 11 is located in a second accommodating groove 350 formed by the two shielding parts 340. In this case, the shaft cover 11 is shielded by the shielding parts 340, and the shaft cover 11 cannot be seen from the outside, so that an appearance of the terminal device at the joint of the two housings 300 in the unfolded state is ensured.

When the two housings 300 move from the unfolded state to the folded state, the two shielding parts 340 are gradually unfolded, and the shaft cover 11 is gradually exposed from the two shielding parts 340. As shown in FIG. 4, when the two housings 300 are in the folded state, the shaft cover 11 is located in a gap formed by the two shielding parts 340, and covers the gap, to prevent a moving part of the hinge mechanism 100 in the gap from being seen from the outside, so that an appearance of the terminal device at the joint of the two housings 300 in the folded state is ensured.

A specific structure of the shaft cover 11 is not unique. In some embodiments, as shown in FIG. 5, the shaft cover 11 includes a shaft cover wall 111, and the shaft cover wall 111 encloses accommodating space 110. For example, as shown in FIG. 5, the shaft cover wall 111 includes a shaft cover bottom wall 112, and a shaft cover side wall 113 disposed at a peripheral edge of the shaft cover bottom wall 112. The shaft cover bottom wall 112 and the shaft cover side wall 113 enclose the accommodating space 110, and the accommodating space 110 may be a U-shaped groove, however, this is not limited thereto. The accommodating space 110 may alternatively be a trapezoidal groove, a semicircular groove, an arc-shaped groove, or the like.

In some other embodiments, the shaft cover wall 111 may be the foregoing structure or may be designed into a flat plate structure.

In some embodiments, as shown in FIG. 5, an avoidance notch 1131 is provided on a position that is of the shaft cover 11 and that corresponds to the swing arm 21. For example, the avoidance notch 1131 is provided on a position that is of the shaft cover side wall 113 and that corresponds to the swing arm 21, and the avoidance notch 1131 is used to avoid the swing arm 21, so as to avoid structural interference between the shaft cover 11 and the swing arm 21 at an unfolding position.

In some embodiments, as shown in FIG. 6 and FIG. 9, the swing arm assembly 2 further includes a bearing member 23. The bearing member 23 and the gear 22 are arranged in the axial direction X of the gear 22, and the bearing member 23 is fastened relative to the base 1 in a circumferential direction of the gear 22. The elastic piece 3 is configured to apply an elastic force F to at least one of the bearing member 23 and the gear 22, so that the bearing member 23 approaches the gear 22.

A structure of the elastic piece 3 is not unique. In some embodiments, as shown in FIG. 6 and FIG. 9, the elastic piece 3 is a spring, and the spring is in a compressed state, and is sleeved on the mounting shaft 15. One end of the spring applies the elastic force F to the gear 22, so that the gear 22 approaches the bearing member 23.

There may be one or more springs. As shown in FIG. 6, each mounting shaft 15 is sleeved with a spring.

In some other embodiments, the elastic piece 3 may be a spring or another elastic component like an elastic sheet.

The elastic piece 3 may apply the elastic force F to the gear 22, or may change a disposing position to apply the elastic force F to the bearing member 23 or apply the elastic force F to both the bearing member 23 and the gear 22 at the same time.

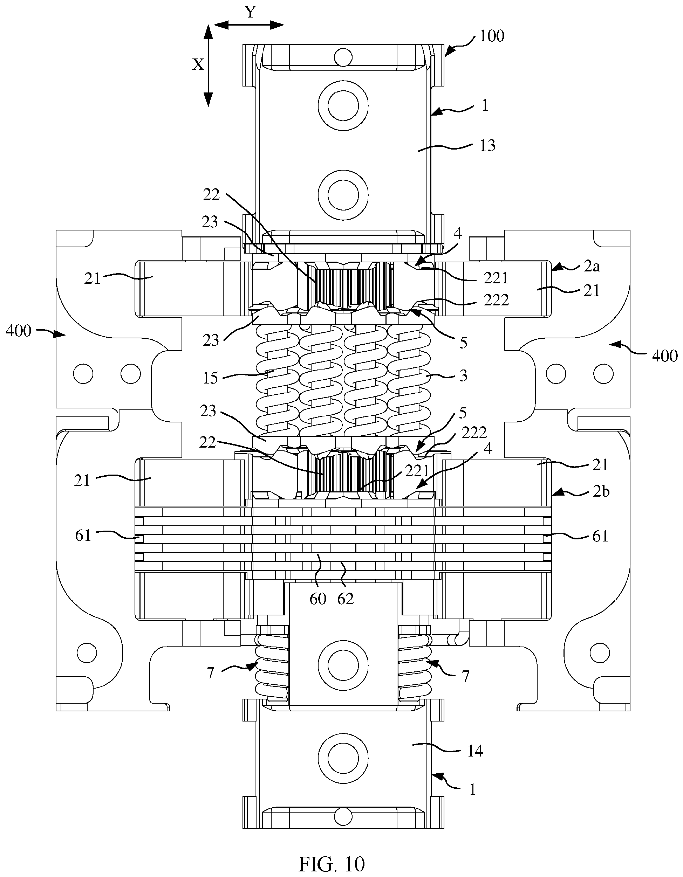

As shown in FIG. 10, FIG. 10 is a B-direction view of the hinge mechanism 100 in FIG. 7. The first cam structure 4 is disposed between the first end face 221 of the gear 22 and the bearing member 23.

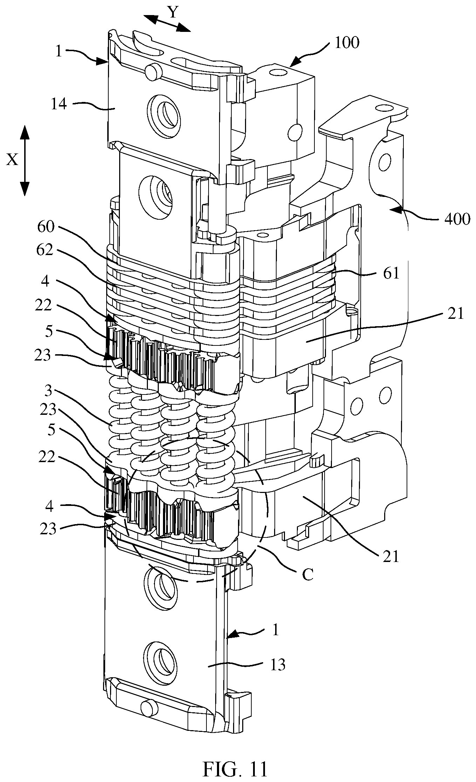

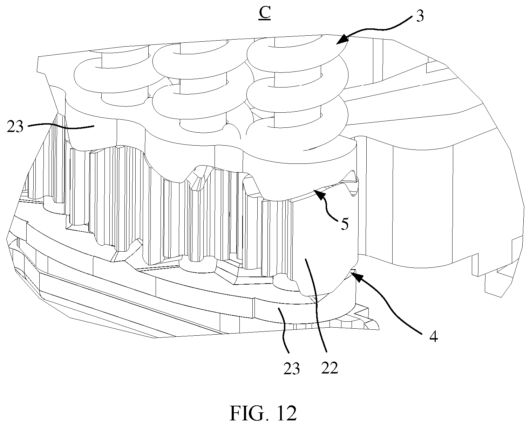

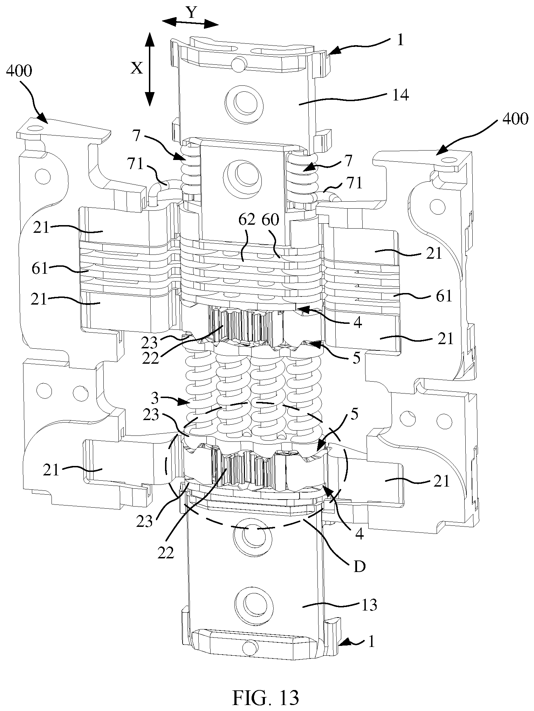

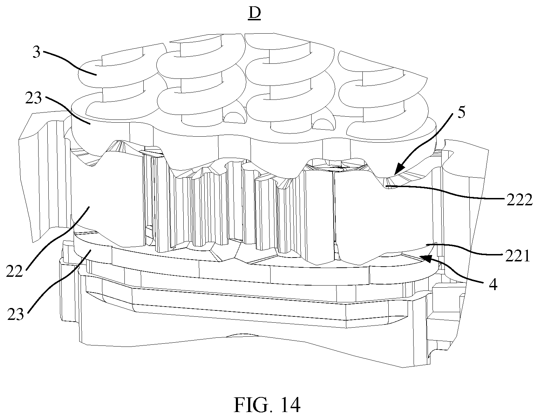

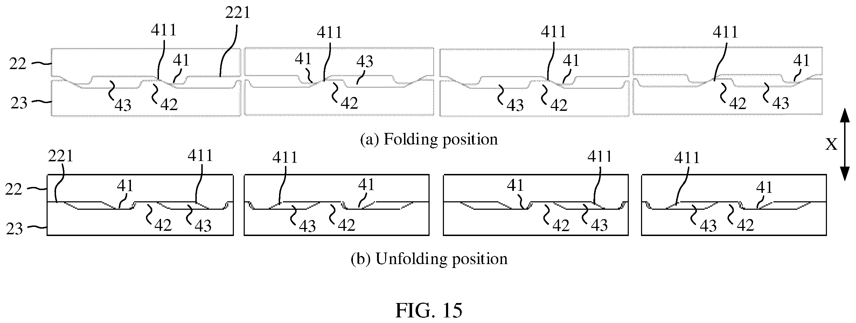

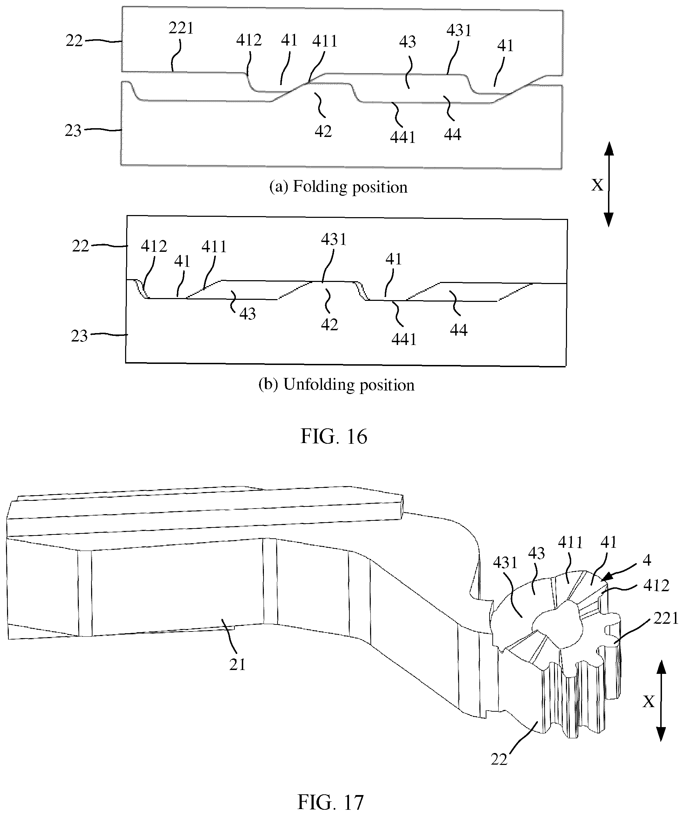

As shown in FIG. 11 to FIG. 16, FIG. 11 is a three-dimensional diagram of the swing arm 21 of the hinge mechanism 100 at a folding position according to a first embodiment of this application; FIG. 12 is a partially enlarged view of the hinge mechanism 100 at C in FIG. 11; FIG. 13 is a three-dimensional diagram of the swing arm 21 of the hinge mechanism 100 at an unfolding position according to the first embodiment of this application; FIG. 14 is a partially enlarged view of the hinge mechanism 100 at D in FIG. 13; FIG. 15 is a circumferentially expanded view of the first cam structure 4 between each of four gears 22 of the swing arm assembly 2 and the bearing member 23 in a case in which the swing arm 21 is at different positions according to the first embodiment of this application; and FIG. 16 is a circumferentially expanded view of the first cam structure 4 between the rightmost gear 22 and the bearing member 23 in FIG. 15 in a case in which the swing arm 21 is at different positions.

The first cam structure 4 includes a first protrusion part 41 disposed on the first end face 221 and a second protrusion part 42 disposed on the bearing member 23, where the first protrusion part 41 includes a first side surface 411. In some embodiments, as shown in FIG. 15 and FIG. 16, the first side surface 411 may be an inclined surface, and the inclined surface is inclined relative to the axial direction X of the gear 22. In some other embodiments, the first side surface 411 may alternatively be a bent curved surface, for example, an arched surface or a parabolic surface.

As shown in FIG. 12, FIG. 15, and FIG. 16, when the swing arm 21 is at the folding position, the second protrusion part 42 abuts against the first side surface 411. Under an action of an elastic force of the elastic piece 3, a component force f1 generated by an extrusion force between the second protrusion part 42 and the first side surface 411 causes the second protrusion part 42 to move relative to or have a tendency of moving relative to the first side surface 411, so as to apply, to the gear 22, an action force that can drive the swing arm 21 to rotate toward the unfolding position.

First, that two components abut against each other in this embodiment of this application specifically means that there is at least one of point contact, line contact, and surface contact between the two components.

Second, in this embodiment of this application, a locking structure is disposed on the housing 300 of the terminal device, and the locking structure has a locked state and an unlocked state. When the locking structure is in the locked state, positions of the two housings 300 are locked, so that the two housings 300 are in a folded state. In this case, the second protrusion part 42 and the first side surface 411 are in a relatively static state, but under an action of the component force f1 generated by the extrusion force between the second protrusion part 42 and the first side surface 411, the second protrusion part 42 and the first side surface 411 have a tendency of moving relative to each other. For example, as shown in (a) in FIG. 16, the gear 22 has a tendency of moving leftward relative to the bearing member 23. When the locking structure is in the unlocked state, as shown in (a) in FIG. 16, the second protrusion part 42 and the first side surface 411 move relative to each other under the action of the component force f1, so that the gear 22 rotates leftward relative to the bearing member 23 (in FIG. 16, the gear 22 rotates leftward to drive the swing arm 21 to move in an unfolding direction, and the gear 22 rotates rightward to drive the swing arm 21 to move in a folding direction), so that the gear 22 drives the swing arm 21 to rotate toward the unfolding position, and the two housings 300 of the terminal device are ejected at a specific angle.

The locking structure may be one of a buckle structure and a magnetic attraction mechanism. The buckle structure includes an elastic buckle disposed on one housing 300 and a buckling hole provided on the other housing 300. When the buckle structure is in a locked state, the elastic buckle may be separately buckled with the buckling hole, and the elastic buckle may be separated from the buckling hole under an external force, so that the buckle structure is in an unlocked state.

The magnetic attraction mechanism includes an electromagnet disposed on one housing 300 and a magnetic attraction component disposed on the other housing 300. When the magnetic attraction mechanism is in a locked state, the electromagnet is powered on to attract the magnetic attraction component. When the magnetic attraction mechanism is in an unlocked state, the electromagnet is powered off to be separated from the magnetic attraction component. The magnetic attraction component may be made of at least one of magnetic materials such as iron, cobalt, and nickel.

According to the hinge mechanism 100 in this embodiment of this application, the first cam structure 4 is disposed between the bearing member 23 and the gear 22. When the swing arm 21 is at the folding position, the second protrusion part 42 and the first side surface 411 of the first protrusion part 41 press against each other and move relative to each other through the elastic force of the elastic piece 3, so that the swing arm 21 is driven to unfold by the gear 22, to achieve an effect that the housing 300 of the terminal device automatically ejects after the locking structure is switched to the unlocked state.

Compared with the hinge mechanism 100 in the conventional technology, in the hinge mechanism 100 in this embodiment of this application, the elastic piece 3 applies the elastic force F to at least one of the bearing member 23 and the gear 22, so that the bearing member 23 approaches the gear 22, to ensure that the second protrusion part 42 can abut against the first side surface 411. In this way, in a process in which the swing arm 21 rotates from the folding position to the unfolding position, a deformation amplitude of the elastic piece 3 is determined by relative displacements of the first protrusion part 41 and the second protrusion part 42 in the axial direction X of the gear 22, that is, the deformation amplitude of the elastic piece 3 is determined by a height of the first protrusion part 41. Because the height of the first protrusion part 41 is smaller than a rotation displacement of the swing arm 21 relative to the base 1, a problem that the deformation amplitude of the elastic piece 3 is large can be avoided, and a reaction force on the elastic piece 3 can be reduced. This helps prolong a service life of the elastic piece 3, so that the elastic piece 3 can provide the stable elastic force F to at least one of the bearing member 23 and the gear 22, to ensure stability of an ejecting angle of housings 300 of the terminal device.

In addition, according to the hinge mechanism 100 in this embodiment of this application, an ejection force (namely, the component force f1 generated by the extrusion force between the second protrusion part 42 and the first side surface 411) generated by the first cam structure 4 in a case in which the swing arm 21 is at the folding position may be synchronously transferred to a pair of swing arms 21 in the swing arm assembly 2 through an even number of gears 22. In this way, the same ejection force is applied to the pair of swing arms 21, so that the stability of the pair of swing arms 21 can be improved in the process of ejecting, and the pair of swing arms 21 can be ejected at a same angle.

In some embodiments, as shown in FIG. 15 and FIG. 16, there are a plurality of first protrusion parts 41, the plurality of first protrusion parts 41 are arranged in a circumferential direction of the gear 22, a first notch 43 is formed between two adjacent first protrusion parts 41, and when the swing arms 21 are at a folding position and an unfolding position, the second protrusion part 42 extends into a same first notch 43. In this way, when the swing arm 21 rotates between the folding position and the unfolding position, the second protrusion part 42 can avoid crossing the first protrusion part 41. In this way, a displacement of the second protrusion part 42 relative to the first protrusion part 41 in the axial direction X of the gear 22 can be reduced, so that a deformation amplitude of the elastic piece 3 can be smaller, to further prolong a service life of the elastic piece 3.

It should be understood that: If the second protrusion part 42 extends into a same first notch 43 when the swing arms 21 are at the folding position and the unfolding position, a center angle corresponding to the first notch 43 in a circumferential direction of the gear 22 is greater than or equal to 90 degrees as the swing arm 21 rotates 90 degrees from the folding position to the unfolding position, and the gear 22 in transmission connection to the swing arm 21 also rotates 90 degrees, that is, the gear 22 rotates a quarter circle. In this case, the center angle corresponding to the first notch 43 in the circumferential direction of the gear 22 is greater than or equal to 90 degrees, so that the second protrusion part 42 has sufficient space in the first notch 43.

In some embodiments, as shown in FIG. 16 and FIG. 17, FIG. 17 is a diagram of the first cam structure 4 disposed on the gear 22 connected to the swing arm 21 in the hinge mechanism 100 according to the first embodiment of this application. There are two first protrusion parts 41.

Certainly, a quantity of first protrusion parts 41 is not limited to two, and may also be three, one, or the like, which may be specifically determined based on an actual situation.

In some embodiments, as shown in FIG. 16 and FIG. 17, a first bottom surface 431 is disposed in the first notch 43, the first bottom surface 431 is perpendicular to the axial direction X of the gear 22, and when the swing arm 21 is at the unfolding position, the second protrusion part 42 abuts against the first bottom surface 431. Compared with the case in which the first bottom surface 431 is inclined relative to the axial direction X of the gear 22, in a case in which the first bottom surface 431 is perpendicular to the axial direction X of the gear 22, the second protrusion part 42 and the first bottom surface 431 can be prevented from moving relative to each other under an action of an elastic force of the elastic piece 3, to ensure stability between relative positions of the second protrusion part 42 and the first protrusion part 41, so that the swing arm 21 is stably at the unfolding position, and stability of the terminal device in the unfolded state can be ensured.

In some embodiments, as shown in FIG. 16, the first protrusion part 41 includes a second side surface 412. In the circumferential direction of the gear 22, the second side surface 412 is disposed opposite to the first side surface 411. An inclination angle of the second side surface 412 relative to the axial direction X of the gear 22 is less than an inclination angle of the first side surface 411 relative to the axial direction X of the gear 22, that is, the second side surface 412 is steeper than the first side surface 411. The second side surface 412 is connected to a first side surface 411 of an adjacent first protrusion part 41 through the first bottom surface 431. Compared with a case in which the inclination angle of the second side surface 412 is set to be consistent with that of the first side surface 411, in a case in which the inclination angle of the second side surface 412 relative to the axial direction X of the gear 22 is less than the inclination angle of the first side surface 411 relative to the axial direction X of the gear 22, a transverse distance between the first side surface 411 and the second side surface 412 on a same first protrusion part 41 may be increased, thereby reducing abrasion of the first protrusion part 41 in folding and unfolding processes of the swing arm 21, and helping prolonging a service life of a product.

In some embodiments, as shown in FIG. 16, when the swing arm 21 is at the folding position, the second protrusion part 42 is in surface contact with the first side surface 411. In other words, there is a flat surface in a lateral direction of the second protrusion part 42. When the swing arm 21 is at the folding position, the flat surface in the lateral direction of the second protrusion part 42 is in surface contact with the first side surface 411. In this design, pressure of interaction between the second protrusion part 42 and the first side surface 411 can be reduced, thereby reducing a probability of damage between the first protrusion part 41 and the second protrusion part 42.

In some embodiments, as shown in FIG. 16, when the swing arm 21 is at the unfolding position, the second protrusion part 42 is in surface contact with the first bottom surface 431. In other words, there is a flat surface on a top of the second protrusion part 42. When the swing arm 21 is at the unfolding position, the flat surface on the top of the second protrusion part 42 is in surface contact with the first bottom surface 431. In this way, a contact area between the second protrusion part 42 and the first bottom surface 431 may be increased, so that the second protrusion part 42 is unlikely to shake along the first bottom surface 431 when the swing arm 21 is at the unfolding position. This can reduce shake of the swing arm 21 at the unfolding position, and further ensure stability of the terminal device in the unfolded state.

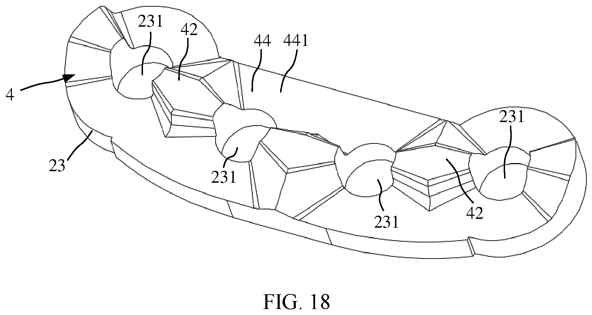

In some embodiments, as shown in FIG. 16 and FIG. 18, FIG. 18 is a diagram of the first cam structure 4 disposed on the bearing member 23 in the hinge mechanism 100 according to a first embodiment of this application. There are a plurality of second protrusion parts 42, the plurality of second protrusion parts 42 are arranged in the circumferential direction of the gear 22, a third notch 44 for a corresponding first protrusion part 41 to extend into is formed between two adjacent second protrusion parts 42, and each second protrusion part 42 extends into a corresponding first notch 43. The plurality of second protrusion parts 42 are disposed, so that when the swing arm 21 is at the folding position, the plurality of second protrusion parts 42 may press against the corresponding first protrusion parts 41, to improve contact stress of the first cam structure 4. This helps avoid a form change of the first cam structure 4 in a use process.

A quantity of second protrusion parts 42 is equal to a quantity of first protrusion parts 41. For example, as shown in FIG. 16, both the quantity of second protrusion parts 42 and the quantity of first protrusion parts 41 are two.

In some embodiments, as shown in FIG. 16, a third bottom surface 441 is disposed in the third notch 44, the third bottom surface 441 is perpendicular to the axial direction X of the gear 22, and when the swing arm 21 is at the unfolding position, the first protrusion part 41 is in surface contact with the third bottom surface 441. In other words, there is a flat surface on a top of the first protrusion part 41. When the swing arm 21 is at the unfolding position, the flat surface on the top of the first protrusion part 41 is in surface contact with the third bottom surface 441. In this way, a contact area between the first protrusion part 41 and the third bottom surface 441 may be increased, so that the first protrusion part 41 is unlikely to shake along the third bottom surface 441 when the swing arm 21 is at the unfolding position. This can reduce shake of the swing arm 21 at the unfolding position, and further ensure stability of the terminal device in the unfolded state.

In this embodiment of this application, a plurality of second protrusion parts 42 or one second protrusion part 42 may be disposed in the first cam structure 4. Positions of the first protrusion part 41 and the second protrusion part 42 in the first cam structure 4 may also be exchanged, that is, the first protrusion part 41 is disposed on the bearing member 23, and the second protrusion part 42 is disposed on the first end face 221 of the gear 22, so that a same effect can also be achieved.

In some embodiments, as shown in FIG. 14 and FIG. 15, in the swing arm assembly 2, the first cam structure 4 is disposed between each gear 22 and the bearing member 23. In this design, when the swing arm 21 is at the folding position, an action force may be applied by a corresponding first cam structure 4 to each gear 22. In this way, a large torque can be generated to drive the swing arm 21 to rotate toward the unfolding position, so that the first cam structure 4 can be adapted to a terminal device that needs a large torque to eject.

In a process of rotating the swing arm 21 from the unfolding position to the folding position, the gear 22 is used as a reference. Because the second protrusion part 42 needs to "climb" along the first side surface 411 of the first protrusion part 41, the swing arm 21 moves in the axial direction X with the outermost gear 22. To ensure that the swing arm 21 can smoothly move in the axial direction X of the gear 22, the swing arm 21 is movably connected to the housing 300 in the axial direction X of the gear 22. For example, as shown in FIG. 6, there is a motion gap among the swing arm 21 and groove walls on two sides of the sliding groove 410 of the connection frame 400, so that the swing arm 21 moves in the axial direction X in the sliding groove 410.

Certainly, in the swing arm assembly 2, the first cam structure 4 is disposed between each gear 22 and the bearing member 23, or the first cam structure 4 may be separately disposed between some of the gears 22 and the bearing member 23. Specifically, in the swing arm assembly 2, two outermost gears 22 are fastened to corresponding swing arms 21, and gears 22 (for example, the two gears 22 located in the middle in FIG. 14) other than the outermost two gears 22 are slidably connected to the base 1 in the axial direction X of the gears 22, and the first cam structures 4 are disposed between the gears 22 and the bearing member 23. In this design, in a process in which the swing arm 21 rotates from the unfolding position to the folding position, the gear 22 connected to the swing arm 21 does not move in the axial direction X due to an action force of the first cam structure 4. In this way, the swing arm 21 can be more stable in a process of rotating relative to the base 1.

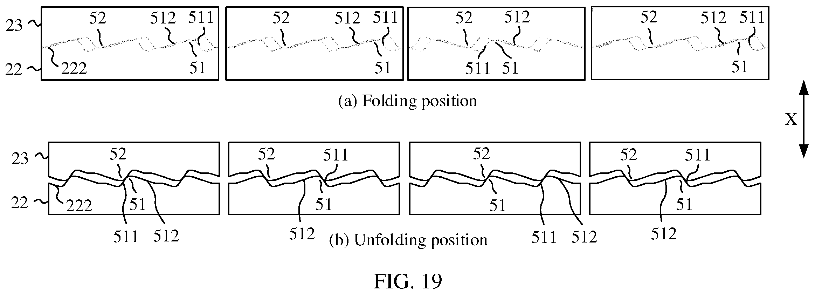

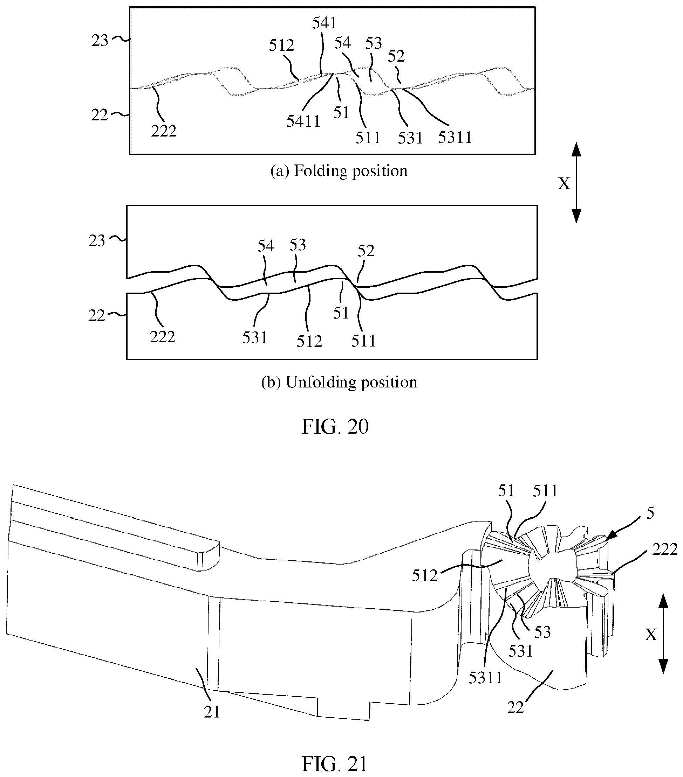

In some embodiments, as shown in FIG. 14, FIG. 19, and FIG. 20, FIG. 19 is a circumferentially expanded view of the second cam structure between each of four gears 22 of the swing arm assembly 2 and the bearing member 23 in a case in which the swing arm 21 is at different positions according to the first embodiment of this application. FIG. 20 is a circumferentially expanded view of the second cam structure between the rightmost gear 22 and the bearing member 23 in FIG. 19 in a case in which the swing arm 21 is at different positions.

The hinge mechanism 100 further includes a second cam structure 5 disposed between the second end face 222 of the gear 22 and the bearing member 23. The second cam structure 5 includes a third protrusion part 51 disposed on the second end face 222 and a fourth protrusion part 52 disposed on the bearing member 23. The third protrusion part 51 includes a third side surface 511, where the third side surface 511 may be an inclined surface, and the inclined surface is disposed relative to the axial direction X of the gear 22. The third side surface 511 may be the inclined surface, or may be a bent curved surface, for example, an arched surface or a parabolic surface.

When the swing arm 21 is at an unfolding position, the fourth protrusion part 52 abuts against the third side surface 511. Under an action of an elastic force of the elastic piece 3, a component force f2 generated by an extrusion force between the fourth protrusion part 52 and the third side surface 511 causes the fourth protrusion part 52 and the third side surface 511 to have a tendency of moving relative to each other, so as to apply, to the gear 22, an action force that can prevent the swing arm 21 from rotating in a direction close to the folding position, as shown in (b) in FIG. 20. The action force (namely, an unfolding force) may enable the gear 22 to have a tendency of rotating leftward (in FIG. 20, the gear 22 rotates leftward to drive the swing arm 21 to move in an unfolding direction, and the gear 22 rotates rightward to drive the swing arm 21 to move in a folding direction), so that shake of the swing arm 21 at the unfolding position is avoided, and the swing arm 21 is stably at the unfolding position. In this way, the terminal device can be stably kept in the unfolded state, thereby improving user experience.

In some embodiments, as shown in FIG. 20, the third protrusion part 51 includes a fourth side surface 512. In a circumferential direction of the gear 22, the fourth side surface 512 is disposed opposite to the third side surface 511, and an inclination angle of the fourth side surface 512 relative to the axial direction X of the gear 22 is greater than an inclination angle of the third side surface 511 relative to the axial direction X of the gear 22.

In a process in which the swing arm 21 rotates from the folding position to the unfolding position, with reference to the gear 22, the fourth protrusion part 52 needs to pass through the third protrusion part 51 along the fourth side surface 512, and then abuts against the third side surface 511 of the third protrusion part 51. Because the inclination angle of the fourth side surface 512 relative to the axial direction X of the gear 22 is greater than the inclination angle of the third side surface 511 relative to the axial direction X of the gear 22, that is, the fourth side surface 512 is smoother than the third side surface 511, difficulty of crossing the third protrusion part 51 by the fourth protrusion part 52 is reduced, and resistance of the fourth protrusion part 52 when "climbing" along the fourth side surface 512 is reduced, so that the swing arm 21 can smoothly rotate from the folding position to the unfolding position. In this way, the terminal device can be ensured to smoothly switch to an unfolded state.

Certainly, positions of the third protrusion part 51 and the fourth protrusion part 52 may also be exchanged, that is, the third protrusion part 51 is disposed on the bearing member 23, and the fourth protrusion part 52 is disposed on the second end face 222 of the gear 22. In this way, resistance of the fourth protrusion part 52 when "climbing" along the fourth side surface 512 may also be reduced.

In some embodiments, as shown in FIG. 20 and FIG. 21, FIG. 21 is a diagram of the second cam structure 5 disposed on the gear 22 connected to the swing arm 21 in the hinge mechanism 100 according to the first embodiment of this application. There are a plurality of third protrusion parts 51, the plurality of third protrusion parts 51 are arranged in a circumferential direction of the gear 22, a second notch 53 is formed between two adjacent third protrusion parts 51, a first positioning part 531 is disposed in the second notch 53, and when the swing arm 21 is at the folding position, the first positioning part 531 positions the fourth protrusion part 52. The first positioning part 531 is disposed to position the fourth protrusion part 52. In this way, the fourth protrusion part 52 is unlikely to shake when the swing arm 21 is at the folding position, thereby reducing shake of the swing arm 21 at the folding position, and further ensuring stability of the terminal device in a folded state.

A structure of the first positioning part 531 is not unique. In some embodiments, as shown in FIG. 20, the first positioning part 531 includes a first positioning surface 5311 that is perpendicular to the axial direction X of the gear 22. When the swing arm 21 is at the folding position, the fourth protrusion part 52 is in surface contact with the first positioning surface 5311. In other words, a top of the fourth protrusion part 52 has a flat surface. When the swing arm 21 is at the folding position, the flat surface on the top of the fourth protrusion part 52 is in surface contact with the first positioning surface 5311. The first positioning part 531 is disposed as the first positioning surface 5311 and is in surface contact with the fourth protrusion part 52, so that a positioning structure is simpler. This helps reduce processing difficulty, and helps reduce processing costs.

The first positioning part 531 may be the first positioning surface 5311 or may be a positioning slot, a magnetic attraction member, or the like. When the first positioning part 531 is the positioning slot, a structure matching the positioning slot is disposed on the top of the fourth protrusion part 52. When the first positioning part 531 is a magnetic attraction member, a magnetic piece that can be attracted by the magnetic attraction member is disposed on the top of the fourth protrusion part 52, where both the magnetic attraction member and the magnetic piece may be magnets.

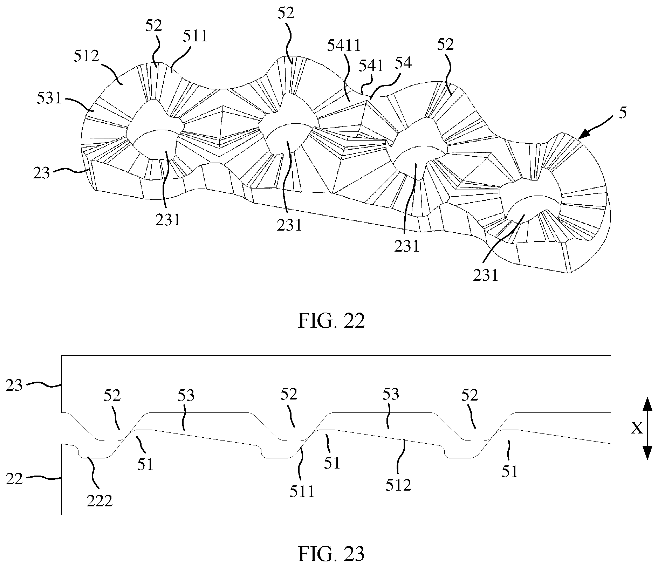

Certainly, the first positioning part 531 may not be disposed in the second notch 53. As shown in FIG. 23, FIG. 23 is a diagram of another structure of the second cam structure 5 according to an embodiment of this application. In FIG. 23, the first positioning surface 5311 in FIG. 20 is removed. When the swing arm 21 is at the unfolding position, the fourth protrusion part 52 abuts against the fourth side surface 512.

In some embodiments, as shown in FIG. 20 and FIG. 22, FIG. 22 is a diagram of the second cam structure 5 disposed on the bearing member 23 in the hinge mechanism 100 according to the first embodiment of this application. There are a plurality of fourth protrusion parts 52, the plurality of fourth protrusion parts 52 are arranged in a circumferential direction of the gear 22, and a fourth notch 54 for the third protrusion part 51 to extend into is formed between two adjacent fourth protrusion parts 52. The plurality of fourth protrusion parts 52 are disposed, so that when the swing arm 21 is at an unfolding position, the plurality of fourth protrusion parts 52 may press against the corresponding third protrusion parts 51, to reduce contact stress, thereby effectively prolonging a service life of the second cam structure 5.

A quantity of fourth protrusion parts 52 is equal to a quantity of third protrusion parts 51. For example, as shown in FIG. 20, both the quantity of fourth protrusion parts 52 and the quantity of third protrusion parts 51 are three. Certainly, the quantity of the fourth protrusion parts 52 and the quantity of the third protrusion parts 51 are not limited to three, and may alternatively be four, six, eight, or the like, which may be specifically determined based on an actual situation.

In some embodiments, as shown in FIG. 20, a second positioning part 541 is disposed in the fourth notch 54. When the swing arm 21 is at a folding position, the second positioning part 541 positions the third protrusion part 51. The second positioning part 541 is disposed to position the third protrusion part 51. In this way, the third protrusion part 51 is unlikely to shake when the swing arm 21 is at the folding position, thereby reducing shake of the swing arm 21 at the folding position, and further ensuring stability of the terminal device in a folded state.

A structure of the second positioning part 541 is not unique. In some embodiments, as shown in FIG. 20, the second positioning part 541 includes a second positioning surface 5411 that is perpendicular to the axial direction X of the gear 22. When the swing arm 21 is at the folding position, the third protrusion part 51 is in surface contact with the second positioning surface 5411. In other words, a top of the third protrusion part 51 has a flat surface. When the swing arm 21 is at the folding position, the flat surface on the top of the third protrusion part 51 is in surface contact with the second positioning surface 5411. The second positioning part 541 is disposed as the second positioning surface 5411 and is in surface contact with the third protrusion part 51, so that a positioning structure is simpler. This helps reduce processing difficulty, and helps reduce processing costs.

The second positioning part 541 may be the second positioning surface 5411 or may be a positioning slot, a magnetic attraction member, or the like. When the second positioning part 541 is the positioning slot, a structure matching the positioning slot is disposed on the top of the third protrusion part 51. When the second positioning part 541 is a magnetic attraction member, a magnetic piece that can be attracted by the magnetic attraction member is disposed on the top of the third protrusion part 51, where both the magnetic attraction member and the magnetic piece may be magnets.

In this embodiment of this application, a plurality of fourth protrusion parts 52 or one fourth protrusion part 52 may be disposed in the second cam structure 5.

In some embodiments, as shown in FIG. 14 and FIG. 19, in the swing arm assembly 2, the second cam structure 5 is disposed between each gear 22 and the bearing member 23. In this design, when the swing arm 21 is at an unfolding position, an action force may be applied by a corresponding second cam structure 5 to each gear 22. In this way, a large unfolding force can be generated to prevent the swing arm 21 from rotating toward a folding position, so that the terminal device can be more stable in an unfolded state.

Certainly, in the swing arm assembly 2, the second cam structure 5 is disposed between each gear 22 and the bearing member 23, or the second cam structure 5 may be separately disposed between some of the gears 22 and the bearing member 23. Specifically, in the swing arm assembly 2, two outermost gears 22 are fastened to the corresponding swing arms 21, and gears 22 (for example, the two gears 22 located in the middle in FIG. 14) other than the outermost two gears 22 are slidably connected to the base 1 in the axial direction X of the gears 22, and the second cam structures 5 are disposed between the gears 22 and the bearing member 23. In this design, in a process in which the swing arm 21 rotates from the folding position to the unfolding position, the gear 22 connected to the swing arm 21 does not move in the axial direction X due to an action force of the second cam structure 5. In this way, the swing arm 21 can be more stable in a process of rotating relative to the base 1.

In some embodiments, as shown in FIG. 10 to FIG. 14, in the swing arm assembly 2, bearing members 23 are respectively disposed on two sides of the gear 22, the first end face 221 and the second end face 222 are respectively two end faces that are of the gear 22 and that are disposed opposite to each other, the first cam structure 4 is disposed between the first end face 221 and a bearing member 23 on a corresponding side, and the second cam structure 5 is disposed between the second end face 222 and a bearing member 23 on a corresponding side.

In this embodiment, the first cam structure 4 and the second cam structure 5 are distributed on two sides of a same gear 22, and the first cam structure 4 and the second cam structure 5 are arranged in a same swing arm assembly 2. In this way, the terminal device can implement dual functions of self-ejecting in a folded state and keeping a stable unfolded state through a same swing arm assembly 2.

In some embodiments, as shown in FIG. 10, two swing arm assemblies 2 are disposed between the first sub-base 13 and the second sub-base 14, which are respectively a swing arm assembly 2a and a swing arm assembly 2b. The swing arm assembly 2a is disposed close to the first sub-base 13, and the swing arm assembly 2b is disposed close to the second sub-base 14.

In the swing arm assembly 2a, an upper end face of the gear 22 is the first end face 221, a lower end face of the gear 22 is the second end face 222, the first cam structure 4 is disposed between the upper end face of the gear 22 and the bearing member 23 located on an upper side of the gear 22, and the second cam structure 5 is disposed between the lower end face of the gear 22 and the bearing member 23 located on a lower side of the gear 22.

In the swing arm assembly 2b, an upper end face of the gear 22 is the second end face 222, a lower end face of the gear 22 is the first end face 221, the second cam structure 5 is disposed between the upper end face of the gear 22 and the bearing member 23 located on an upper side of the gear 22, and the first cam structure 4 is disposed between the lower end face of the gear 22 and the bearing member 23 located on a lower side of the gear 22.

As shown in FIG. 10, the elastic piece 3 is a spring, the spring is in a compressed state, and is sleeved on the mounting shaft 15 between the swing arm assembly 2a and the swing arm assembly 2b. One end of the elastic piece 3 abuts against the bearing member 23 located on the lower side of the gear 22 in the swing arm assembly 2a, and the other end of the elastic piece 3 abuts against the bearing member 23 located on the upper side of the gear 22 in the swing arm assembly 2b.

In some embodiments, as shown in FIG. 10, in the swing arm assembly 2a, the bearing member 23 located on the upper side of the gear 22 is fastened to the first sub-base 13. For example, the bearing member 23 located on the upper side of the gear 22 and the first sub-base 13 may be of an integrated structure. A plurality of through holes 231 are provided on the bearing member 23 located on the lower side of the gear 22, and the mounting shaft 15 penetrates each through hole 231.

In the swing arm assembly 2b, a plurality of through holes 231 are provided on each of the bearing members 23 located on the upper side and the lower side of the gear 22, and the mounting shaft 15 penetrates each through hole 231. The bearing member 23 located on the lower side of the gear 22 and the second friction member 62 of the damping mechanism 6 may be of an integrated structure, and the damping mechanism 6 is described in detail in the following.

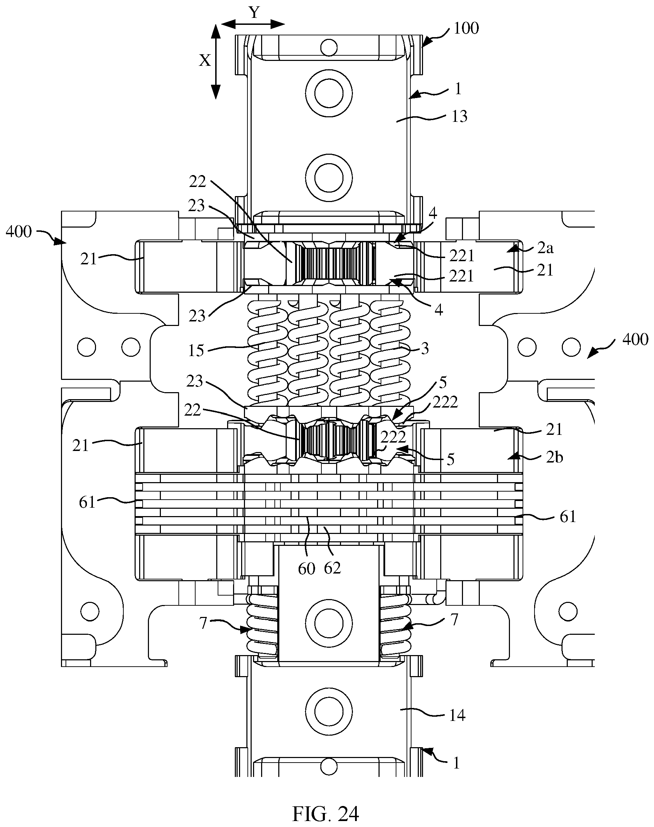

FIG. 24 is a diagram of the swing arm 21 in the hinge mechanism 100 at an unfolding position according to a second embodiment of this application. A main difference between the hinge mechanism 100 in the second embodiment of this application and the hinge mechanism 100 in the first embodiment lies in that the first cam structure 4 and the second cam structure 5 are disposed in different manners.

In some embodiments, as shown in FIG. 24, in the swing arm assembly 2 (for example, the swing arm assembly 2 located on an upper side in the figure), bearing members 23 are respectively disposed on two sides of the gear 22, the gear 22 has two first end faces 221 that are disposed opposite to each other, and the first cam structure 4 is disposed between each first end face 221 and a bearing member 23 on a corresponding side, that is, the two sides of the gear 22 are disposed on the first cam structure 4. In this way, when the swing arm 21 is at a folding position, the first cam structures 4 on the two sides of the gear 22 may generate a large ejection force, so that the hinge mechanism 100 can be adapted to a terminal device that needs a large torque to eject.

When there are a plurality of swing arm assemblies 2, the first cam structures 4 may be disposed on two sides of the gear 22 in a part of the swing arm assemblies 2, or the first cam structures 4 may be disposed on two sides of the gear 22 in each swing arm assembly 2. This is not specifically limited herein.

In some embodiments, as shown in FIG. 24, there are a plurality of swing arm assemblies 2, and the plurality of swing arm assemblies 2 are arranged in the axial direction X of the gear 22. In a part of the swing arm assemblies 2, bearing members 23 are respectively disposed on two sides of the gear 22, the gear 22 has two second end faces 222 disposed opposite to each other, and the second cam structure 5 is disposed between each second end face 222 and a bearing member 23 on a corresponding side. In the other part of swing arm assemblies 2, bearing members 23 are respectively disposed on two sides of the gear 22, the gear 22 has two first end faces 221 disposed opposite to each other, and the first cam structure 4 is disposed between each first end face 221 and a bearing member 23 on a corresponding side.

In this embodiment, in a same group of swing arm assemblies 2, the first cam structures 4 or the second cam structures 5 are disposed on two sides of the gear 22, that is, cam structures of a same type are disposed on the two sides of the gear 22. In this way, when the gear 22 is mounted reversely, normal rotation of the swing arm 21 can still be ensured, and a positive or negative direction of the gear 22 does not need to be determined during assembling, thereby facilitating assembling of the gear 22. In addition, in a part of the swing arm assemblies 2, the second cam structures 5 are disposed on two sides of the gear 22. In this way, when the swing arm 21 is at an unfolding position, the second cam structures 5 on the two sides of the gear 22 may generate a large unfolding force, to prevent the terminal device from folding, so that the hinge mechanism 100 can adapt to a terminal device that requires a large torque to maintain an unfolded state.

For example, as shown in FIG. 24, the swing arm assembly 2a and the swing arm assembly 2b are disposed between the first sub-base 13 and the second sub-base 14. In the swing arm assembly 2a, both an upper end face and a lower end face of the gear 22 are the first end faces 221, and the first cam structure 4 is separately disposed between the upper end face of the gear 22 and the bearing member 23 located on the upper side of the gear 22, and between the lower end face of the gear 22 and the bearing member 23 located on the lower side of the gear 22. In the swing arm assembly 2b, both an upper end face and a lower end face of the gear 22 are second end faces 222, and the second cam structure 5 is separately disposed between the upper end face of the gear 22 and the bearing member 23 located on the upper side of the gear 22, and between the lower end face of the gear 22 and the bearing member 23 located on the lower side of the gear 22.

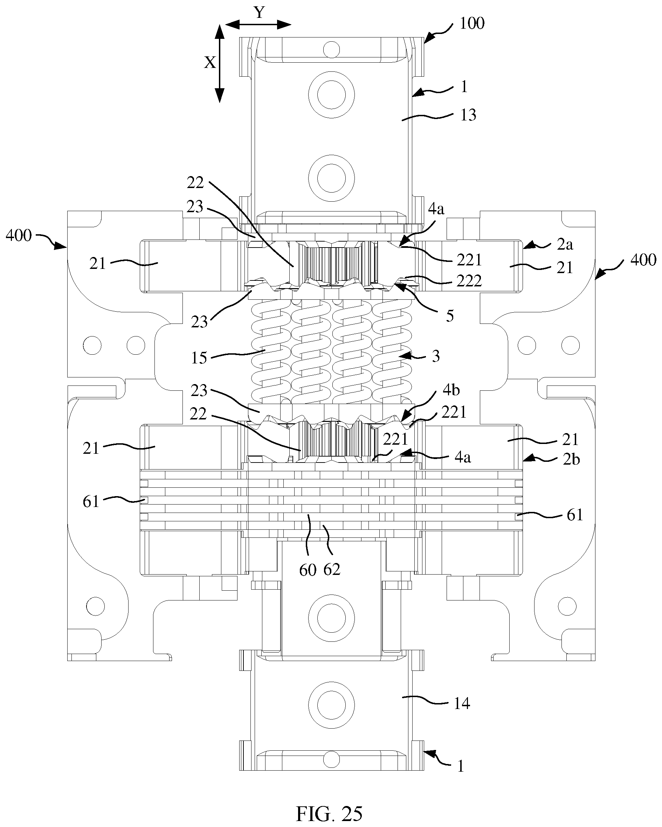

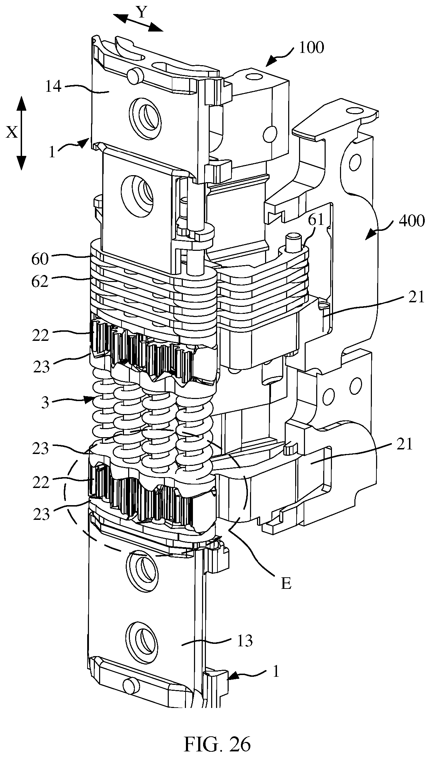

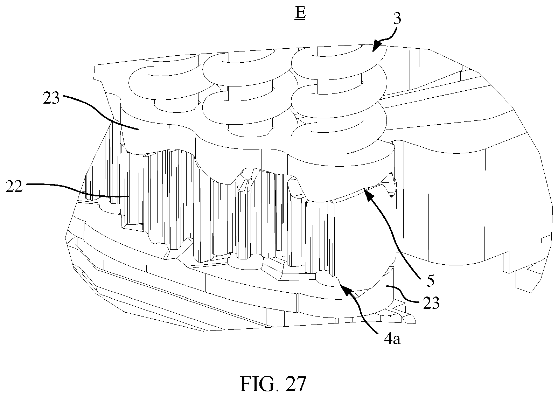

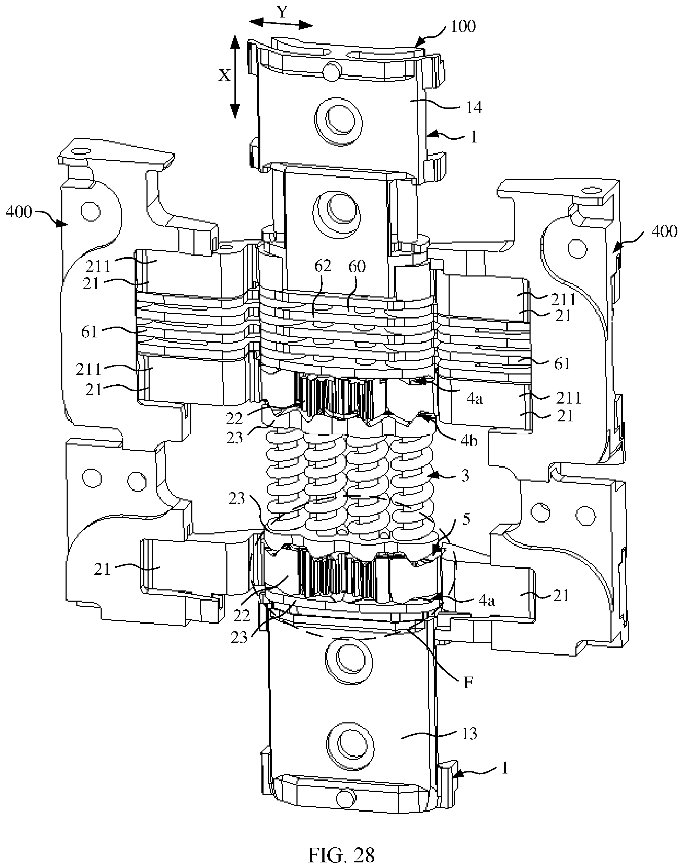

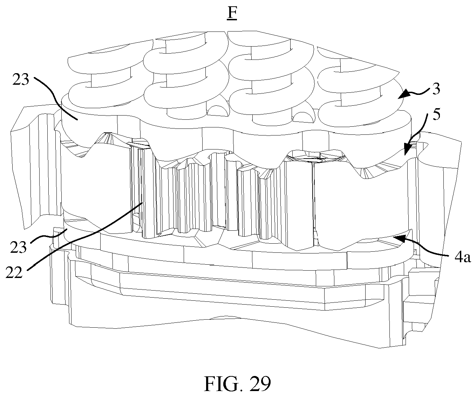

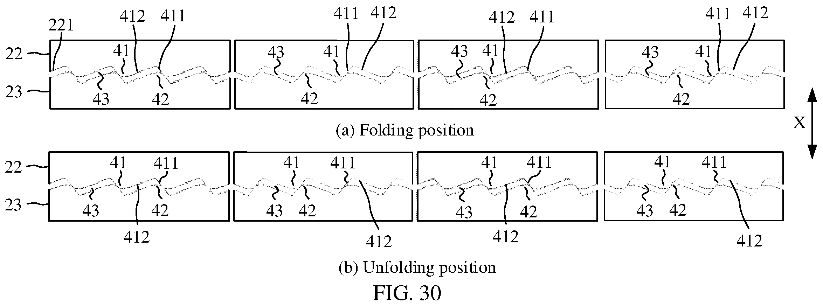

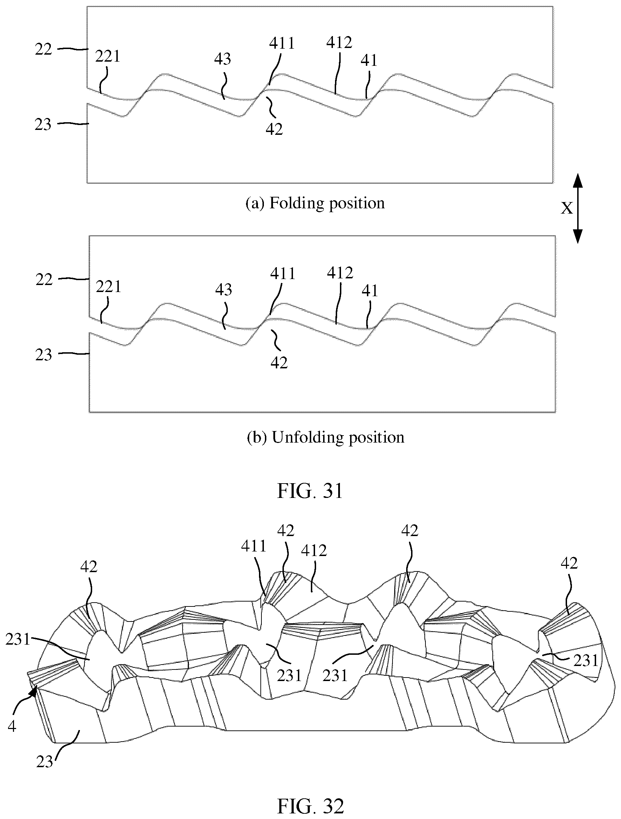

As shown in FIG. 25 to FIG. 31, FIG. 25 is a diagram of the swing arm 21 in the hinge mechanism 100 at an unfolding position according to a third embodiment of this application; FIG. 26 is a three-dimensional diagram of the swing arm 21 of the hinge mechanism 100 at a folding position according to the third embodiment of this application; FIG. 27 is a partially enlarged view of the hinge mechanism 100 in FIG. 26 at E; FIG. 28 is a three-dimensional diagram of the swing arm 21 of the hinge mechanism 100 at the unfolding position according to the third embodiment of this application; FIG. 29 is a partially enlarged view of the hinge mechanism 100 in FIG. 28 at F; FIG. 30 is a circumferentially expanded view of the first cam structure 4 between each of four gears 22 of the swing arm assembly 2 and the bearing member 23 in a case in which the swing arm 21 is at different positions according to the third embodiment of this application; and FIG. 31 is a circumferentially expanded view of the first cam structure 4 between the rightmost gear 22 and the bearing member 23 in FIG. 30 in a case in which the swing arm 21 is at different positions.

A main difference between the hinge mechanism 100 in the third embodiment of this application and the hinge mechanism 100 in the first embodiment lies in that a structure of the first cam structure 4 is different.

There are a plurality of first protrusion parts 41, and the plurality of first protrusion parts 41 are arranged in a circumferential direction of the gear 22. As shown in FIG. 31, when the swing arm 21 is at a folding position, the second protrusion part 42 abuts against a first side surface 411 of one first protrusion part 41; and when the swing arm 21 is at an unfolding position, the second protrusion part 42 abuts against a first side surface 411 of another first protrusion part 41.

When the swing arm 21 is at the folding position and the unfolding position, the second protrusion part 42 separately abuts against first side surfaces 411 of different first protrusion parts 41. In this way, when the swing arm 21 is at the unfolding position and the folding position, under an action of an elastic force of the elastic piece 3, both the second protrusion part 42 and the first side surface 411 may press against each other to apply an unfolding force to the swing arm 21 through the gear 22. In this case, the terminal device may have dual functions of self-ejecting in a folded state and keeping a stable unfolded state through the first cam structure 4, that is, the first cam structure 4 in this embodiment has effects of both the first cam structure 4 and the second cam structure 5. In this way, a layout of the cam structure is more compact, and a size of the swing arm assembly 2 is reduced when a same function is implemented.

In some embodiments, as shown in FIG. 30 and FIG. 31, an inclined angle of the second side surface 412 of the first protrusion part 41 relative to an axial direction X of the gear 22 is greater than an inclined angle of the first side surface 411 relative to the axial direction X of the gear 22.

In a process in which the swing arm 21 rotates from the folding position to the unfolding position, with reference to the gear 22, the second protrusion part 42 needs to cross the first protrusion part 41 along the second side surface 412, and then abuts against the first side surface 411 of the first protrusion part 41. Because the inclination angle of the second side surface 412 relative to the axial direction X of the gear 22 is greater than the inclination angle of the first side surface 411 relative to the axial direction X of the gear 22, that is, the second side surface 412 is smoother than the first side surface 411, difficulty of crossing the first protrusion part 41 by the second protrusion part 42 is reduced, and resistance of the second protrusion part 42 when "climbing" along the second side surface 412 is reduced, so that the swing arm 21 can smoothly rotate from the folding position to the unfolding position. In this way, the terminal device can be ensured to smoothly switch to an unfolded state.

In some embodiments, as shown in FIG. 31, in the circumferential direction of the gear 22, a center angle corresponding to a distance between first side surfaces 411 of two adjacent first protrusion parts 41 is 90 degrees.

In a process in which the swing arm 21 rotates by 90 degrees from the folding position to the unfolding position, the gear 22 in transmission connection to the swing arm 21 also rotates by 90 degrees, that is, the gear 22 rotates by a quarter circle. A center angle corresponding to a distance between first side surfaces 411 of two adjacent first protrusion parts 41 is set to 90 degrees, so that the second protrusion part 42 may move from a first side surface 411 of one first protrusion part 41 to a first side surface 411 of an adjacent first protrusion part 41. In this way, a quantity of first protrusion parts 41 crossed by the second protrusion parts 42 can be reduced, to reduce rotation resistance of the swing arm 21, so that a process of switching the terminal device to the unfolded state is smoother.

The distance between the first side surfaces 411 of the two adjacent first protrusion parts 41 specifically refers to: a distance between same positions on the first side surfaces 411 of the two adjacent first protrusion parts 41. For example, a point O1 is located on a top of one first side surface 411, and a point O2 is located on a top of an adjacent first side surface 411. In this case, in the circumferential direction of the gear 22, a distance between the point O1 and the point O2 is a distance between the first side surfaces 411 of the two adjacent first protrusion parts 41.

In some embodiments, as shown in FIG. 31, there are four first protrusion parts 41, and the four first protrusion parts 41 are continuously arranged.

"Continuous arrangement" means that in two adjacent first protrusion parts 41, a first side surface 411 of one first protrusion part 41 is connected to a second side surface 412 of the other first protrusion part 41.

In some embodiments, as shown in FIG. 31 and FIG. 32, FIG. 32 is a diagram of the first cam structure 4 disposed on the bearing member 23 in the hinge mechanism 100 according to the third embodiment of this application. There are a plurality of second protrusion parts 42, the plurality of second protrusion parts 42 are arranged in a circumferential direction of the gear 22, and each second protrusion part 42 may extend into a corresponding first notch 43.

The plurality of second protrusion parts 42 are disposed, so that when the swing arm 21 is at a folding position and an unfolding position, the plurality of second protrusion parts 42 separately abut against corresponding first protrusion parts 41, to improve contact stress between the protrusion parts. This helps ensure that the first cam structure 4 works normally and stably, and effectively prolongs a service life of the first cam structure 4.

A quantity of second protrusion parts 42 is equal to a quantity of first protrusion parts 41. For example, as shown in FIG. 31, both the quantity of second protrusion parts 42 and the quantity of first protrusion parts 41 are four.

In some embodiments, as shown in FIG. 31, when the swing arm 21 is at the folding position and the unfolding position, the second protrusion part 42 is in surface contact with the first side surface 411. In other words, there is a flat surface in a lateral direction of the second protrusion part 42. When the swing arm 21 is at the folding position and the unfolding position, the flat surface in the lateral direction of the second protrusion part 42 is in surface contact with the first side surface 411. In this design, pressure of interaction between the second protrusion part 42 and the first side surface 411 can be reduced, thereby reducing a probability of damage between the first protrusion part 41 and the second protrusion part 42.

In some embodiments, as shown in FIG. 25 to FIG. 29, there are a plurality of swing arm assemblies 2, and the plurality of swing arm assemblies 2 are arranged in the axial direction X of the gear 22. In a part of the swing arm assemblies 2, bearing members 23 are respectively disposed on two sides of the gear 22, the gear 22 has the first end face 221 and the second end face 222 disposed opposite to each other, the first cam structure 4 is disposed between the first end face 221 and a bearing member 23 on a corresponding side, and the second cam structure 5 is disposed between the second end face 222 and a bearing member 23 on a corresponding side. In the other part of swing arm assemblies 2, bearing members 23 are respectively disposed on two sides of the gear 22, the gear 22 has two first end faces 221 disposed opposite to each other, and the first cam structure 4 is disposed between each first end face 221 and a bearing member 23 on a corresponding side.

In some embodiments, as shown in FIG. 25, in the swing arm assembly 2 in which the first cam structure 4 is disposed, a first cam structure 4a is disposed between one first end face 221 of the gear 22 and a bearing member 23 on a corresponding side, and a first cam structure 4b is disposed between the other first end face 221 of the gear 22 and a bearing member 23 on a corresponding side.

It should be noted that, for differentiation, a first cam structure 4 (for example, the first cam structure 4 shown in FIG. 10 to FIG. 18) that meets a condition that "when the swing arms 21 are at the folding position and the unfolding position, the second protrusion part 42 extends into a same first notch 43" is referred to as the first cam structure 4a. A first cam structure 4 (for example, the first cam structure 4 shown in FIG. 25 to FIG. 32) that meets a condition that "when the swing arm 21 is at the folding position, the second protrusion part 42 abuts against a first side surface 411 of one first protrusion part 41; and when the swing arm 21 is at the unfolding position, the second protrusion part 42 abuts against a first side surface 411 of the other first protrusion part 41 " is referred to as the first cam structure 4b.

For example, as shown in FIG. 25, the swing arm assembly 2a and the swing arm assembly 2b are disposed between the first sub-base 13 and the second sub-base 14. In the swing arm assembly 2a, an upper end face of the gear 22 is the first end face 221, a lower end face of the gear 22 is the second end face 222, the first cam structure 4a is disposed between the upper end face of the gear 22 and a bearing member 23 located on an upper side of the gear 22, and the second cam structure 5 is disposed between the lower end face of the gear 22 and a bearing member 23 located on the lower side of the gear 22. In the swing arm assembly 2b, both an upper end face and a lower end face of the gear 22 are first end faces 221, the first cam structure 4b is disposed between the upper end face of the gear 22 and a bearing member 23 located on an upper side of the gear 22, and the first cam structure 4a is disposed between the lower end face of the gear 22 and a bearing member 23 located on a lower side of the gear 22.

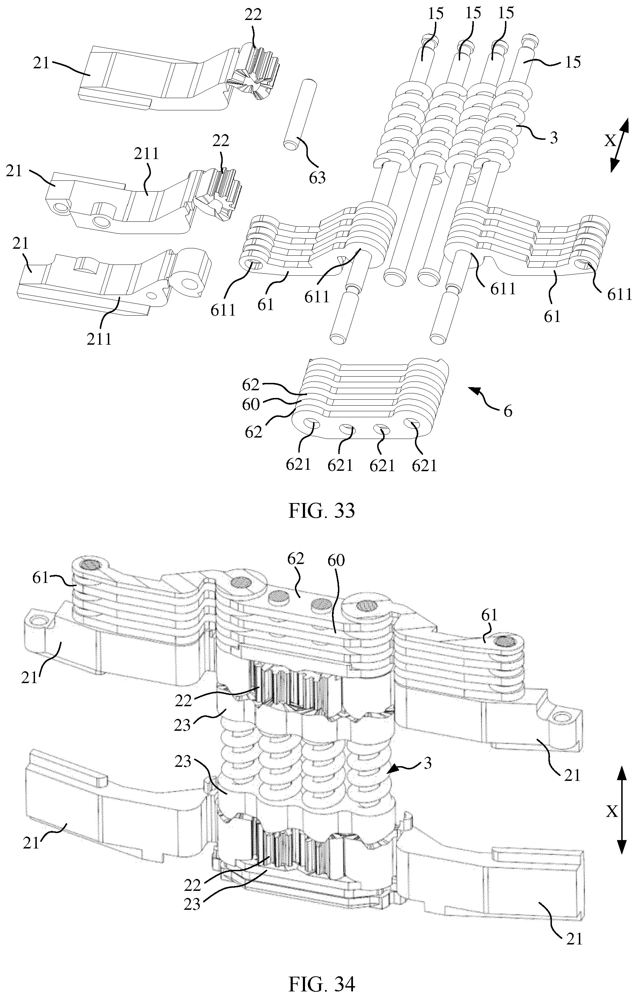

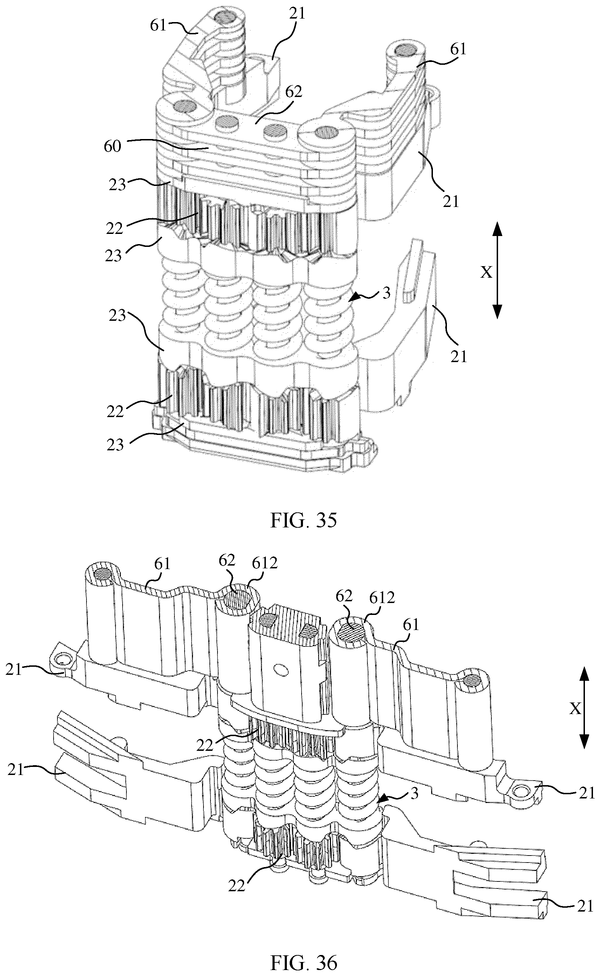

In some embodiments, as shown in FIG. 28 and FIG. 33 to FIG. 35, FIG. 33 is an exploded view of the damping mechanism 6 of the hinge mechanism 100 shown in FIG. 28; FIG. 34 is a sectional view of a first friction member after removal of the connection frame 400 from the hinge mechanism 100 shown in FIG. 28; and FIG. 35 is a sectional view of a first friction member after removal of the connection frame 400 from the hinge mechanism 100 shown in FIG. 26. The hinge mechanism 100 in this embodiment of this application further includes a damping mechanism 6. The damping mechanism 6 includes a first friction member 61 and a second friction member 62. The first friction member 61 is rotatably connected to the base 1, and the first friction member 61 is connected to the swing arm 21 through the connector 63, so that the first friction member 61 and the swing arm 21 can rotate synchronously relative to the base 1. The second friction member 62 is disposed on the base 1, and is in contact with the first friction member 61. When the swing arm 21 rotates between a folding position and an unfolding position, the second friction member 62 may rub against the first friction member 61, to apply a rotation damping force to the swing arm 21.

The damping mechanism 6 is disposed. When the swing arm 21 rotates between the folding position and the unfolding position, the damping mechanism 6 may provide a rotation damping force in a direction opposite to a movement direction of the swing arm 21. In this way, the housing 300 connected to the swing arm 21 can be suspended at a middle position between an unfolded state and a folded state, so that the terminal device can be unfolded at a proper angle to facilitate use by a user. In addition, the damping mechanism 6 provides a rotation damping force through contact friction between the first friction member 61 and the second friction member 62. In this way, a structure of the damping mechanism 6 is simple. When one of the first friction member 61 and the second friction member 62 is damaged, the first friction member 61 or the second friction member 62 may be replaced, and the entire damping mechanism 6 does not need to be replaced. This helps reduce maintenance costs.

The first friction member 61 and the second friction member 62 are not disposed uniquely. FIG. 33 to FIG. 35 show an embodiment in which the first friction member 61 and the second friction member 62 are disposed in a first manner. In this embodiment, there are a plurality of first friction members 61 and a plurality of second friction members 62, the plurality of first friction members 61 and the plurality of second friction members 62 are arranged in the axial direction X of the gear 22, a first gap 60 is formed between two adjacent second friction members 62, each first friction member 61 is inserted into a corresponding first gap 60, and is in contact with an adjacent second friction member 62.

In this design, the first friction member 61 and the adjacent second friction member 62 rub against each other, so that a rotation damping force can be provided for the swing arm 21 in an entire process of rotating the swing arm 21 between the folding position and the unfolding position, the housing 300 connected to the swing arm 21 can be suspended at the middle position between the unfolded state and the folded state, and a large ejection speed, due to an ejection force provided by the first cam structure 4, of the housing 300 of the terminal device can be avoided. In this way, the housing 300 of the terminal device moves more smoothly. In addition, a friction force generated between friction members is changed by adjusting a quantity of first friction members 61 and second friction members 62 (for example, the generated friction force is increased by increasing the quantity of friction members). A magnitude of the rotation damping force can be conveniently adjusted, so that the damping mechanism 6 can be rotated to adapt to terminal devices that require different rotation damping forces. This helps improve universality of the damping mechanism 6.

In some embodiments, as shown in FIG. 28 and FIG. 33, the swing arm 21 includes two swing sub-arms 211 that are both rotatably connected to the base 1, the two swing sub-arms 211 are spaced from each other in the axial direction X of the gear 22, and the two swing sub-arms 211 are connected through a connector 63, so that the two swing sub-arms 211 can rotate synchronously relative to the base 1, and one swing sub-arm 211 is in transmission connection to the gear 22. The first friction member 61 is disposed between the two swing sub-arms 211 and is connected to the connector 63, and the second friction member 62 is disposed between the gear 22 and a limiting part on the base 1.

The first friction member 61 is disposed between the two swing sub-arms 211, and the second friction member 62 is disposed between the gear 22 and the limiting part on the base 1. In this way, the two swing sub-arms 211 can limit the first friction member 61, to prevent the first friction member 61 from fluttering in the axial direction X of the gear 22. The limiting part on the gear 22 and the base 1 can limit the second friction member 62, so that there is contact pressure between the first friction member 61 and the second friction member 62, to ensure a magnitude of a friction force between the first friction member 61 and the second friction member 62.

The connector 63 may be connected between the two swing sub-arms 211 through clamping, inserting, hinging, or screwing. The connector 63 may be rod-shaped, or may be in another shape, which is not specifically limited herein.

For example, as shown in FIG. 28, FIG. 33, and FIG. 34, the connector 63 is rod-shaped, one end of the connector 63 is inserted into a hole on one swing sub-arm 211, and the other end of the connector 63 is inserted into a hole on the other swing sub-arm 211.

The first friction member 61 may be mounted in the following way: A first assembling hole 611 is separately provided at two ends of the first friction member 61, and a first mounting hole at one end of the first friction member 61 fits the connector 63. A first assembling hole 611 at the other end of the first friction member 61 rotatably fits the mounting shaft 15, so that the first friction member 61 is rotatably connected to the base 1.

The second friction member 62 may be mounted in the following way: A plurality of third assembling holes 621 are provided on the second friction member 62 in a width direction Y of the base 1, each third assembling hole 621 fits a corresponding mounting shaft 15, and the second friction member 62 is located between the gear 22 and the second sub-base 14, where the second sub-base 14 is a limiting part of the base 1.

In some embodiments, as shown in FIG. 28 and FIG. 33, both the first friction member 61 and the second friction member 62 are friction plates, and parts that are of the plurality of first friction members 61 and that are close to the base 1 and the plurality of second friction members 62 are staggered and stacked. In this way, the first friction member 61 is in surface contact with an adjacent first friction member 61, so that a large rotation damping force can be provided.

Certainly, the first friction member 61 and the second friction member 62 are not limited to being sheet-shaped, and the first friction member 61 and the second friction member 62 may alternatively be set in another shape, for example, a rod shape, which may be specifically determined based on an actual situation.

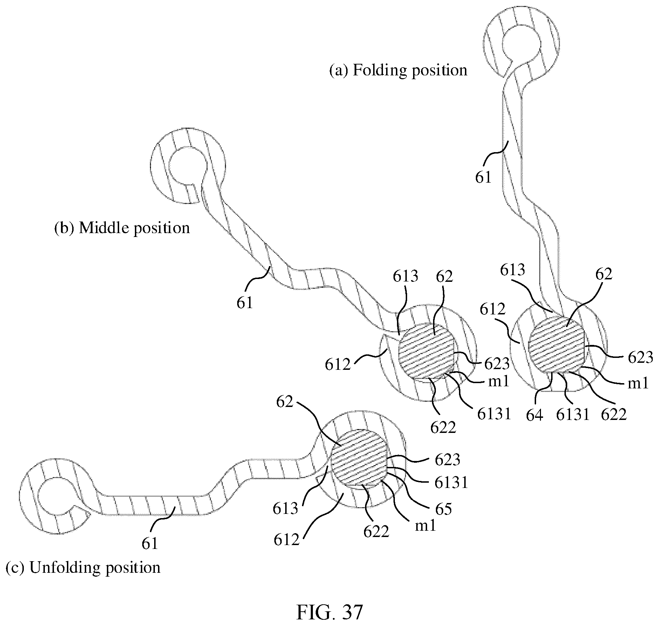

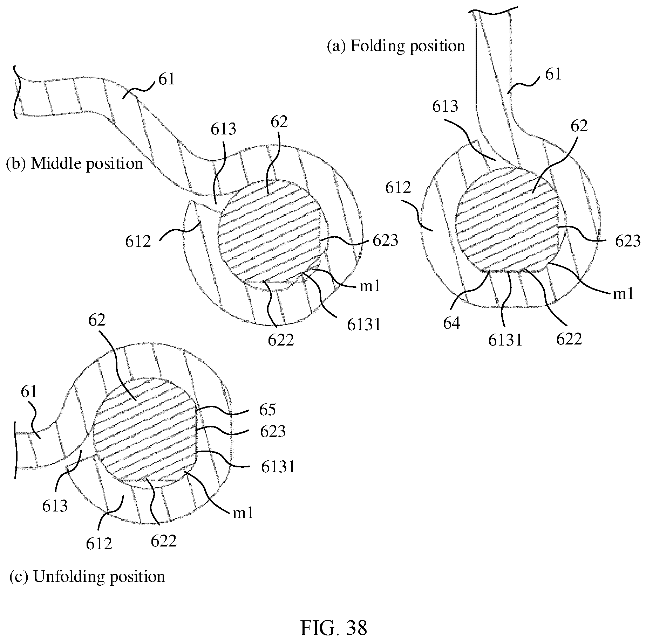

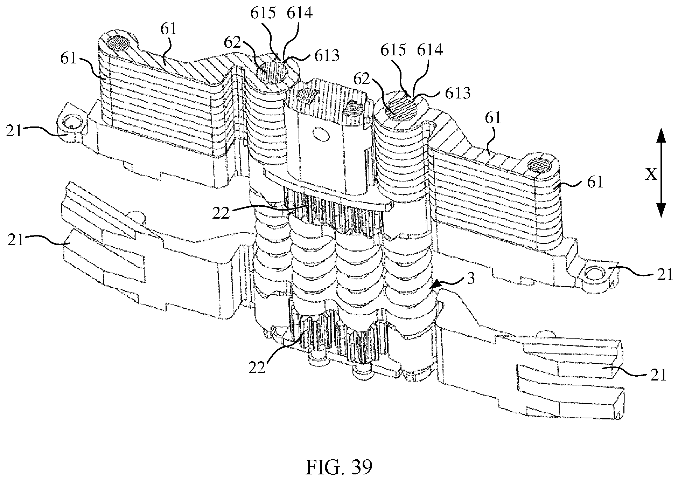

FIG. 36 to FIG. 39 show an embodiment in which the first friction member 61 and the second friction member 62 are disposed in a second manner. FIG. 36 is a diagram of another structure of the damping mechanism 6 in the hinge mechanism 100 according to an embodiment of this application; FIG. 37 is a diagram of a position relationship between the first friction member 61 and the second friction member 62 in a rotation process in FIG. 36; FIG. 38 is a partially enlarged view of a joint between the first friction member 61 and the second friction member 62 in FIG. 37; and FIG. 39 is a diagram of a third structure of the damping mechanism 6 in the hinge mechanism 100 according to an embodiment of this application.

In this embodiment, the first friction member 61 includes an elastic part 612, a flat hole 613 is provided on the elastic part 612, and a hole wall of the flat hole 613 has a first flat surface 6131 in a circumferential direction of the flat hole 613. The second friction member 62 is a flat shaft disposed on the base 1, and in a circumferential direction of the flat shaft, the flat shaft is fastened relative to the base 1, the flat shaft has a second flat surface 622 and a third flat surface 623 that are spaced from each other, and the flat shaft penetrates the flat hole 613. As shown in FIG. 37 and FIG. 38, when the swing arm 21 is at a folding position, the first flat surface 6131 is disposed opposite to the second flat surface 622. When the swing arm 21 is at an unfolding position, the first flat surface 6131 is disposed opposite to the third flat surface 623.

That the first flat surface 6131 is disposed opposite to the second flat surface 622 means that the first flat surface 6131 is parallel to or approximately parallel to the second flat surface 622 (for example, a deviation is within 5 degrees). That the first flat surface 6131 is disposed opposite to the third flat surface 623 means that the first flat surface 6131 is parallel to or approximately parallel to the third flat surface 623 (for example, a deviation is within 5 degrees).

Because the flat shaft is fastened relative to the base 1 in the circumferential direction of the flat shaft, and the flat shaft penetrates the flat hole 613. As shown in FIG. 37 and FIG. 38, when the swing arm 21 rotates between the folding position and the unfolding position, the first friction member 61 rotates relative to the flat shaft. As the first flat surface 6131 of the flat hole 613 moves relative to the second flat surface 622 on the flat shaft, a corner part m1 that is located at an edge of the second flat surface 622 and that is on the flat shaft presses against a hole wall of the flat hole 613. In this way, the flat shaft and the hole wall of the flat hole 613 rub against each other, to provide a rotation damping force to the swing arm 21.

**In** this embodiment, when the swing arm 21 is at the folding position, the first flat surface 6131 is disposed opposite to the second flat surface 622. When the swing arm 21 is at the unfolding position, the first flat surface 6131 is disposed opposite to the third flat surface 623. **In** this way, when the swing arm 21 is at the folding position and the unfolding position, the second friction member 62 (the flat shaft) and the flat hole 613 can be in a stable-fit state. **In** this case, the first friction member 61 can be stably kept at the folding position and the unfolding position, so that the swing arm 21 can be stably kept at the folding position and the unfolding position, and stability of the terminal device in a folded state and an unfolded state can be ensured. **In** addition, in this embodiment, a rotation damping force is provided to the swing arm 21 through friction generated when the first friction member 61 rotates relative to the second friction member 62. Because the second friction member 62 is a flat shaft disposed on the base 1, the elastic part 612 of the first friction member 61 is sleeved on the second friction member 62. **In** this way, the first friction member 61 and the second friction member 62 are more compact and occupy less space.

**In** some embodiments, as shown in FIG. 37 and FIG. 38, when the swing arm 21 is at the folding position, there is a second gap 64 between the first flat surface 6131 and the second flat surface 622. **In** this way, when the swing arm 21 rotates to a position near the folding position (for example, deviates from the folding position within a preset angle), there is sufficient space for the second flat surface 622 to avoid the corner part m1 at the edge of the second flat surface 622, to avoid extrusion between the corner part m1 and the hole wall of the flat hole 613. Therefore, when the swing arm 21 rotates to a position near the folding position, no friction occurs between the first friction member 61 and the second friction member 62, that is, no rotation damping force is provided to the swing arm 21, so that the first cam structure 4 can conveniently eject the housing 300 of the terminal device. This embodiment is applicable to a case in which an ejection force provided by the first cam structure 4 is small.

**In** some embodiments, as shown in FIG. 37 and FIG. 38, when the swing arm 21 is at the unfolding position, there is a third gap 65 between the first flat surface 6131 and the third flat surface 623. **In** this way, when the swing arm 21 rotates to a position near the unfolding position (for example, deviates from the unfolding position within a preset angle), there is sufficient space for the third flat surface 623 to avoid the corner part m1 at the edge of the second flat surface 622, so as to avoid extrusion between the corner part m1 and the hole wall of the flat hole 613. Therefore, when the swing arm 21 rotates to a position near the folding position, no friction occurs between the first friction member 61 and the second friction member 62, that is, no rotation damping force is provided to the swing arm 21, so that the second cam structure 5 can conveniently keep the terminal device at the unfolded state. This embodiment is applicable to a case in which an unfolding force provided by the second cam structure 5 is small.

The preset angle may be 10 degrees, but is not limited thereto. The preset angle may alternatively be 5 degrees, 8 degrees, or the like, which may be specifically determined based on an actual situation. When the preset angle is 10 degrees, and unfolding and folding angles (the included angle between the first display area 210 and the second display area 220 in FIG. 2) of the two housings 300 of the terminal device are between 20° and 160°, the corner part m1 presses against the hole wall of the flat hole 613, and an extrusion force between the corner part m1 and the hole wall of the flat hole 613 is increasingly large in a range of 20° to 90°, and is increasingly small in a range of 90° to 160°. When the unfolding and folding angles of the two housings 300 of the terminal device are 90°, the extrusion force between the corner part m1 and the hole wall of the flat hole 613 is the greatest, and the rotation damping force provided is the greatest.

Certainly, in some other embodiments, when the swing arm 21 is at the folding position, the first flat surface 6131 is attached to the second flat surface 622; or when the swing arm 21 is at the unfolding position, the first flat surface 6131 is attached to the third flat surface 623. In this way, in an entire process in which the swing arm 21 rotates from the folding position to the unfolding position, the corner part m1 presses against the hole wall of the flat hole 613, to provide a rotation damping force to the swing arm 21, so as to avoid an excessively high speed at which the terminal device is ejected under an action of the first cam structure 4 and an excessively high speed at which the terminal device is unfolded under an action of the second cam structure 5. This embodiment is applicable to a case in which the first cam structure 4 provides a large ejection force and the second cam structure 5 provides a large unfolding force.

In some embodiments, as shown in FIG. 36, the elastic part 612 is formed by the first friction member 61 through an edge rolling process. Compared with a case in which the elastic part 612 and a body of the first friction member 61 are disposed separately, in the case in which the elastic part 612 is formed through the edge rolling process, a process of assembling the elastic part 612 is reduced. This not only helps improve assembling efficiency of the damping mechanism 6, but also improves reliability of a connection between the elastic part 612 and the body of the first friction member 61.

In some embodiments, as shown in FIG. 39, the first friction member 61 is of a sheet-like structure, there are a plurality of first friction members 61, the plurality of first friction members 61 are stacked, each first friction member 61 is provided with a notch 614 at the flat hole 613 for breaking the hole wall of the flat hole 613, and notches 614 of the plurality of first friction members 61 form a slot 615 that extends in an axial direction X of the flat shaft. Compared with the case in which the elastic part 612 is formed through the edge rolling process, in the solution in this embodiment, the elastic part 612 (namely, an edge rolling structure) shown in FIG. 36 is split into a plurality of sheet-like structures that are stacked. In this way, the flat hole 613 of the sheet-like elastic part 612 may be formed through a stamping process, and does not need to be manufactured through the edge rolling process. This helps reduce the processing difficulty and costs of the flat hole 613 of the elastic part 612.

In some embodiments, as shown in FIG. 36 and FIG. 39, the second friction member 62 and the mounting shaft 15 are of an integrated structure. Certainly, the second friction member 62 and the mounting shaft 15 may alternatively be disposed, which may be specifically determined based on an actual situation.

For a specific connection relationship between the first friction member 61 and the swing arm 21, refer to the connection relationship between the first friction member 61 and the swing arm 21 in the embodiments shown in FIG. 33 to FIG. 35. Details are not described herein again.

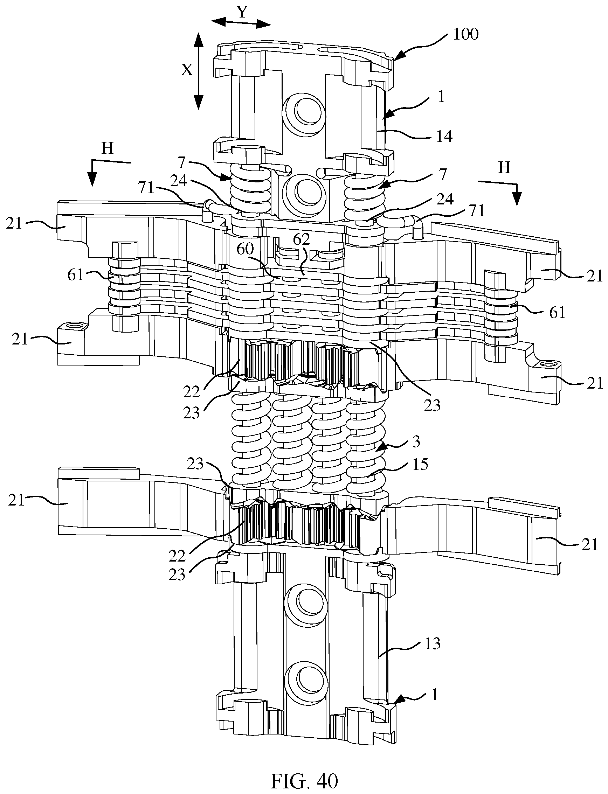

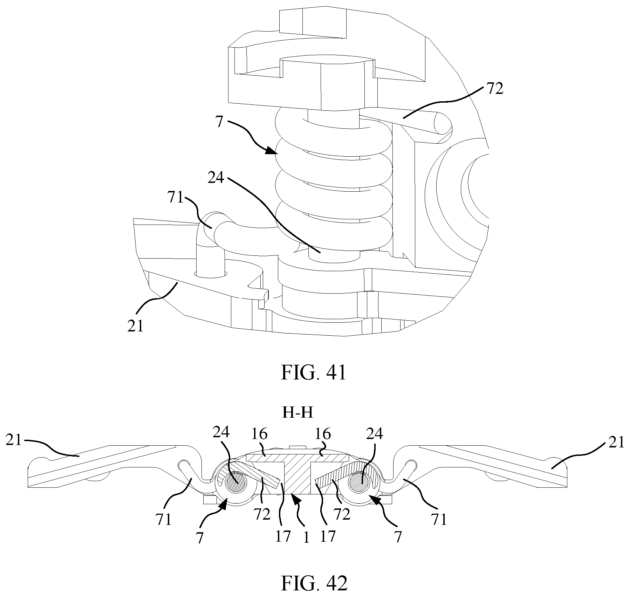

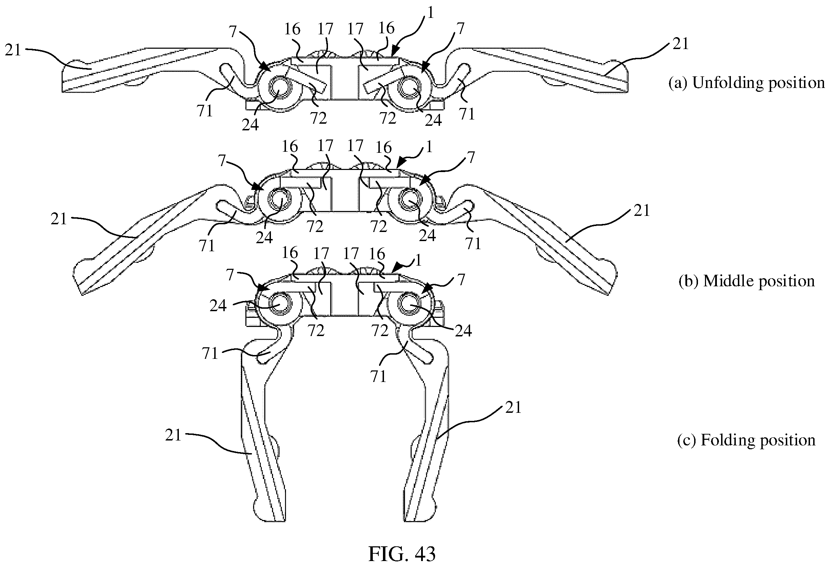

In some embodiments, as shown in FIG. 40 to FIG. 43, FIG. 40 is a diagram of a structure of the hinge mechanism 100 according to some embodiments of this application; FIG. 41 is a partially enlarged view of a position of a torsion spring in the hinge mechanism 100 shown in FIG. 40; FIG. 42 is a sectional view of the hinge mechanism 100 in FIG. 40 at H-H; and FIG. 43 is a status diagram of a torsion spring in a rotation process of the swing arm 21 according to an embodiment of this application. The swing arm 21 is rotatably connected to the base 1 through the rotating shaft 24, a torsion spring 7 is sleeved on the rotating shaft 24, and the first connection arm 71 of the torsion spring 7 is connected to the swing arm 21.

As shown in FIG. 41, the first connection arm 71 is inserted into a hole provided on the swing arm 21, to connect the first connection arm 71 to the swing arm 21. However, this is not limited thereto. The first connection arm 71 may alternatively be connected to the swing arm 21 through clamping, or the like, which may be specifically determined based on an actual situation. The rotating shaft 24 and the mounting shaft 15 of the base 1 may be of an integrated structure, or may be designed separately. This is not specifically limited herein.

A stop part 16 is disposed on the base 1. As shown in FIG. 43, when the swing arm 21 is at an unfolding position, the second connection arm 72 is separated from the stop part 16, so that the torsion spring 7 is in a natural state. When the swing arm 21 rotates between a middle position and a folding position, the second connection arm 72 of the torsion spring 7 presses against the stop part 16, so that the torsion spring 7 is in a force-storage state, to apply, to the swing arm 21, an action force that can drive the swing arm 21 to rotate toward the unfolding position, where the middle position is a position between the folding position and the unfolding position in a rotation direction of the swing arm 21.

The torsion spring 7 is disposed, so that when the swing arm 21 is in a folded state, the torsion spring 7 may apply, to the swing arm 21, an action force that can drive the swing arm 21 to rotate toward the unfolding position, to assist the housing 300 of the terminal device in unfolding. The torsion spring 7 and the first cam structure 4 may be combined to provide a large unfolding force, so that the hinge mechanism 100 is applicable to a terminal device that requires a large unfolding force.

In addition, when the swing arm 21 rotates between the middle position and the folding position, the torsion spring 7 abuts against the stop part 16. That is, the torsion spring 7 abuts against the stop part 16 in a part of a range in which the swing arm 21 rotates toward the folding position, so that a deformation amount of the torsion spring 7 in a case in which the swing arm 21 is at the folding position can be reduced. In this way, a magnitude of a reaction force, to which the torsion spring 7 is subjected, of the swing arm 21 and the stop part 16 can be reduced, so that the torsion spring 7 is not easily damaged due to an excessively large reaction force, and a service life of the torsion spring 7 can be prolonged.

A structure of the stop part 16 is not unique. In some embodiments, as shown in FIG. 41, FIG. 42, and FIG. 43, the stop part 16 is a stop surface disposed on the base 1, and motion space 17 for the second connection arm 72 to swing is disposed between the stop surface and the torsion spring 7. In a process of rotating the swing arm 21, the second connection arm 72 may move in the motion space 17.

As shown in FIG. 43, when the swing arm 21 is at the unfolding position, the second connection arm 72 is located in the motion space 17, and there is a distance between the second connection arm 72 and the stop surface. In this case, the torsion spring 7 does not deform and is in a natural state. When the swing arm 21 rotates between the middle position and the folding position, the second connection arm 72 presses against the stop surface, and the torsion spring 7 deforms to be in a force-storage state, so as to apply, to the swing arm 21, an action force that can drive the swing arm 21 to rotate toward the unfolding position.

The stop surface on the base 1 is set as the stop part 16, so that a structure on the base 1 can be fully used, the structure of the stop part 16 is simple, and other components do not need to be mounted on the base 1. This helps reduce costs.

The motion space 17 is space located between the stop surface and the torsion spring 7. For example, as shown in FIG. 41 and FIG. 42, the motion space 17 may be a cavity on the base 1, the stop part 16 is a cavity wall of the cavity, and a side that is of the cavity and that is close to the torsion spring 7 has an extension hole for the second connection arm 72 to extend into.

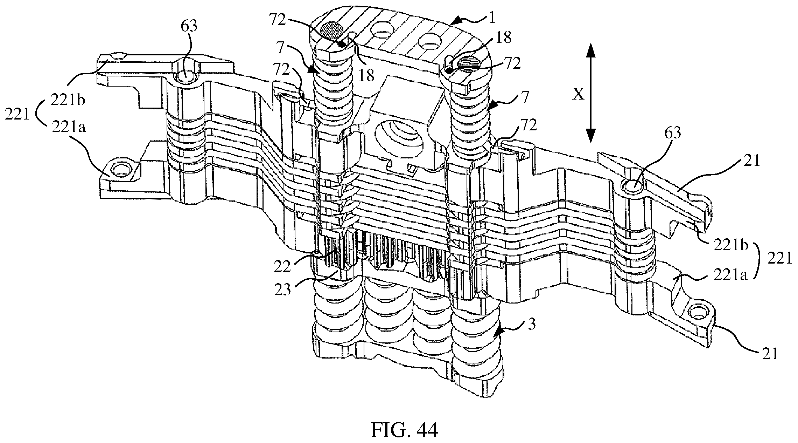

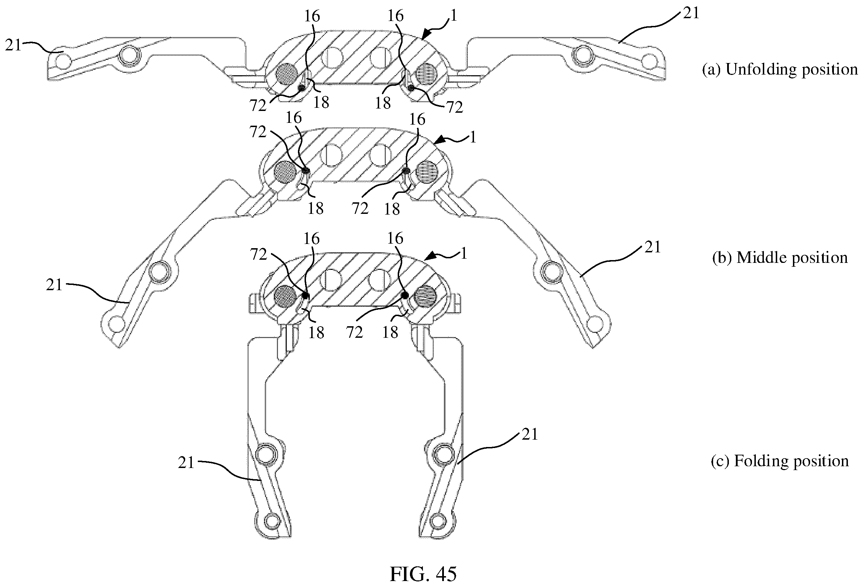

In some other embodiments, as shown in FIG. 44 and FIG. 45, FIG. 44 is a sectional view of the base 1 of the hinge mechanism 100 at a position close to the torsion spring 7 according to some embodiments of this application; and FIG. 45 is a position status diagram of the second connection arm 72 of the torsion spring 7 in a rotation process of the swing arm 21 according to an embodiment of this application. The base 1 is provided with an arc-shaped groove 18 for the second connection arm 72 to extend into, the arc-shaped groove 18 extends in a circumferential direction of the gear 22, and a groove wall at an end of the arc-shaped groove 18 is the stop part 16.

As shown in FIG. 45, when the swing arm 21 is at an unfolding position, the second connection arm 72 is located at a lower end of the arc-shaped groove 18. In this case, the torsion spring 7 does not deform and is in a natural state. When the swing arm 21 rotates between a middle position and the folding position, the second connection arm 72 presses against a groove arm at an upper end of the arc-shaped groove 18, and the torsion spring 7 deforms to be in a force-storage state, so as to apply, to the swing arm 21, an action force that can drive the swing arm 21 to rotate toward the unfolding position.

The groove wall of the arc-shaped groove 18 on the base 1 is set as the stop part 16, so that a structure on the base 1 can be fully used, the structure of the stop part 16 is simple, and other components do not need to be mounted on the base 1. This helps reduce costs. In addition, the arc-shaped groove 18 may also be configured to guide motion of the second connection arm 72, so that shake of the second connection arm 72 in a motion process can be reduced, and the second connection arm 72 moves more smoothly.

In some embodiments, as shown in FIG. 44, the swing arm 21 includes two swing sub-arms 211, the two swing sub-arms 211 are spaced from each other in an axial direction X of the gear 22, and the two swing sub-arms 211 are connected through the connector 63, so that the two swing sub-arms 211 can rotate synchronously relative to the base 1. The two swing sub-arms 211 are a first swing sub-arm 211a and a second swing sub-arm 211b, and the first swing sub-arm 211a is in transmission connection to the gear 22. The torsion spring 7 is located on a side that is of the second swing sub-arm 211b and that is away from the first swing sub-arm 211a, and the second connection arm 72 of the torsion spring 7 is connected to the second swing sub-arm 211b. The torsion spring 7 is disposed on the side that is of the second swing sub-arm 211b and that is away from the first swing sub-arm 211a. In this way, the torsion spring 7 may be disposed away from the gear 22, to avoid structural interference among the torsion spring 7, the gear 22, the bearing member 23, and the like.

The connector 63 may be connected between the two swing sub-arms 211 through clamping, inserting, hinging, or screwing. The connector 63 may be rod-shaped, or may be in another shape, which is not specifically limited herein.

For example, as shown in FIG. 44, the connector 63 is rod-shaped, one end of the connector 63 is inserted into a hole on one swing sub-arm 211, and the other end of the connector 63 is inserted into a hole on the other swing sub-arm 211.

In the descriptions of this specification, the described specific features, structures, materials, or characteristics may be combined in a proper manner in any one or more of embodiments or examples.

The hinge mechanism 100 in embodiments of this application is not limited to being used in a terminal device, and may be further used in a product that needs to be unfolded and folded in the field of automobiles, aircrafts, home appliances, and consumer electronics.

The foregoing embodiments are merely intended to describe the technical solutions of this application, but not intended to limit this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the spirit and scope of the technical solutions of the embodiments of this application.

## Claims

1. A hinge mechanism, comprising:
a base;
a swing arm assembly comprising a bearing member, a pair of swing arms that are rotatably connected to edges of two opposite sides of the base, and an even number of gears, wherein the even number of gears are in transmission connection between the pair of swing arms for each swing arm to be synchronously rotatable relative to the base between a folding position and an unfolding position, the bearing member and the gear are arranged in an axial direction of the gear, and the bearing member is fastened relative to the base in a circumferential direction of the gear;
an elastic piece, configured to apply an elastic force to at least one of the bearing member and the gear for the bearing member to be close to the gear; and
a first cam structure that is disposed between a first end face of the gear and the bearing member and that comprises a first protrusion part disposed on one of the bearing member and the first end face and a second protrusion part disposed on the other of the bearing member and the first end face, wherein the first protrusion part comprises a first side surface, wherein
when the swing arm is at the folding position, the second protrusion part abuts against the first side surface, and under an action of the elastic force, the second protrusion part and the first side surface move relative to each other or have a trend of moving relative to each other, to apply, to the gear, an action force for driving the swing arm to rotate toward the unfolding position.

2. The hinge mechanism according to claim 1, wherein
there are a plurality of first protrusion parts, the plurality of first protrusion parts are arranged in the circumferential direction of the gear, a first notch is formed between two adjacent first protrusion parts, and when the swing arm is at the folding position and the unfolding position, the second protrusion part extends into a same first notch.

3. The hinge mechanism according to claim 2, wherein
a first bottom surface is disposed in the first notch, the first bottom surface is perpendicular to the axial direction of the gear, and when the swing arm is at the unfolding position, the second protrusion part abuts against the first bottom surface.

4. The hinge mechanism according to claim 3, wherein
the first protrusion part comprises a second side surface, in the circumferential direction of the gear, the second side surface is disposed opposite to the first side surface, an inclination angle of the second side surface relative to the axial direction of the gear is less than an inclination angle of the first side surface relative to the axial direction of the gear, and the second side surface is connected to the first side surface of an adjacent first protrusion part through the first bottom surface.

5. The hinge mechanism according to claim 3 or 4, wherein
when the swing arm is at the folding position, the second protrusion part is in surface contact with the first side surface; and/or when the swing arm is at the unfolding position, the second protrusion part is in surface contact with the first bottom surface.

6. The hinge mechanism according to claim 1, wherein
there are a plurality of first protrusion parts, and the plurality of first protrusion parts are arranged in the circumferential direction of the gear; and when the swing arm is at the folding position, the second protrusion part abuts against the first side surface of one first protrusion part; or when the swing arm is at the unfolding position, the second protrusion part abuts against the first side surface of another first protrusion part.

7. The hinge mechanism according to claim 6, wherein
the first protrusion part comprises a second side surface, in the circumferential direction of the gear, the second side surface is disposed opposite to the first side surface, and an inclination angle of the second side surface relative to the axial direction of the gear is greater than an inclination angle of the first side surface relative to the axial direction of the gear; and/or
in the circumferential direction of the gear, a center angle corresponding to a distance between the first side surfaces of two adjacent first protrusion parts is 90 degrees.

8. The hinge mechanism according to any one of claims 1 to 7, wherein
in the swing arm assembly, the first cam structure is disposed between each gear and the bearing member; or two outermost gears are fastened to corresponding swing arms, the gear other than the two outermost gears is slidably connected to the base in the axial direction of the gear, and the first cam structure is disposed between the gear and the bearing member.

9. The hinge mechanism according to any one of claims 1 to 8, wherein
in the swing arm assembly, the bearing members are respectively disposed on two sides of the gear, the gear has two first end faces disposed opposite to each other, and the first cam structure is disposed between each first end face and the bearing member on a corresponding side.

10. The hinge mechanism according to any one of claims 1 to 8, further comprising a second cam structure disposed between a second end face of the gear and the bearing member, wherein
the second cam structure comprises a third protrusion part disposed on one of the bearing member and the second end face and a fourth protrusion part disposed on the other of the bearing member and the second end face, wherein the third protrusion part comprises a third side surface; and
when the swing arm is at the unfolding position, the fourth protrusion part abuts against the third side surface, and under the action of the elastic force of the elastic piece, the fourth protrusion part and the third side surface have a trend of moving relative to each other, to apply, to the gear, an action force for preventing the swing arm from rotating in a direction close to the folding position.

11. The hinge mechanism according to claim 10, wherein
the third protrusion part comprises a fourth side surface, in the circumferential direction of the gear, the fourth side surface is disposed opposite to the third side surface, and an inclination angle of the fourth side surface relative to the axial direction of the gear is greater than an inclination angle of the third side surface relative to the axial direction of the gear.

12. The hinge mechanism according to claim 10 or 11, wherein
there are a plurality of third protrusion parts, the plurality of third protrusion parts are arranged in the circumferential direction of the gear, a second notch is formed between two adjacent third protrusion parts, a first positioning part is disposed in the second notch, and when the swing arm is at the folding position, the first positioning part positions the fourth protrusion part.

13. The hinge mechanism according to claim 12, wherein
the first positioning part comprises a first positioning surface perpendicular to the axial direction of the gear, and when the swing arm is at the folding position, the fourth protrusion part is in surface contact with the first positioning surface.

14. The hinge mechanism according to any one of claims 10 to 13, wherein
in the swing arm assembly, the bearing members are respectively disposed on two sides of the gear, the first end face and the second end face are respectively two end faces disposed opposite to each other of the gear, the first cam structure is disposed between the first end face and the bearing member on a corresponding side, and the second cam structure is disposed between the second end face and the bearing member on a corresponding side; or
there are a plurality of swing arm assemblies, the plurality of swing arm assemblies are arranged in the axial direction of the gear, in a part of the swing arm assemblies, the bearing members are respectively disposed on two sides of the gear, the gear has two second end faces disposed opposite to each other, and the second cam structure is disposed between each second end face and the bearing member on a corresponding side; and in the other part of the swing arm assemblies, the bearing members are respectively disposed on two sides of the gear, the gear has two first end faces disposed opposite to each other, and the first cam structure is disposed between each first end face and the bearing member on a corresponding side.

15. The hinge mechanism according to any one of claims 10 to 14, wherein
in the swing arm assembly, the second cam structure is disposed between each gear and the bearing member; or two outermost gears are fastened to corresponding swing arms, the gear other than the two outermost gears is slidably connected to the base in the axial direction of the gear, and the second cam structure is disposed between the gear and the bearing member.

16. The hinge mechanism according to any one of claims 1 to 15, further comprising a damping mechanism, wherein the damping mechanism comprises:
a first friction member rotatably connected to the base, wherein the first friction member is connected to the swing arm via a connector for the first friction member and the swing arm to be synchronously rotatable relative to the base; and
a second friction member, disposed on the base and in contact with the first friction member, wherein when the swing arm rotates between the folding position and the unfolding position, the second friction member is capable of rubbing against the first friction member, to apply a rotation damping force to the swing arm.

17. The hinge mechanism according to claim 16, wherein
there are a plurality of first friction members and a plurality of second friction members, the plurality of first friction members and the plurality of second friction members are arranged in the axial direction of the gear, a first gap is formed between two adjacent second friction members, and each first friction member is inserted into a corresponding first gap and is in contact with an adjacent second friction member.

18. The hinge mechanism according to claim 16, wherein
the first friction member comprises an elastic part, a flat hole is provided on the elastic part, and a hole wall of the flat hole has a first flat surface in a circumferential direction of the flat hole;
the second friction member is a flat shaft disposed on the base, the flat shaft is fastened relative to the base in a circumferential direction of the flat shaft, the flat shaft has a second flat surface and a third flat surface that are spaced from each other, and the flat shaft penetrates the flat hole; and
when the swing arm is at the folding position, the first flat surface is disposed opposite to the second flat surface; or when the swing arm is at the unfolding position, the first flat surface is disposed opposite to the third flat surface.

19. The hinge mechanism according to claim 18, wherein
when the swing arm is at the folding position, a second gap is provided between the first flat surface and the second flat surface; and/or
when the swing arm is at the unfolding position, a third gap is provided between the first flat surface and the third flat surface.

20. The hinge mechanism according to claim 18 or 19, wherein
the elastic part is formed by the first friction member through an edge rolling process; or the first friction member is a sheet-like structure, there are a plurality of first friction members, the plurality of first friction members are stacked, each first friction member is provided with a notch at the flat hole for breaking the hole wall of the flat hole, and the notches of the plurality of first friction members form a slot extending in an axial direction of the flat shaft.

21. The hinge mechanism according to any one of claims 1 to 20, wherein
the swing arm is rotatably connected to the base through a rotating shaft, a torsion spring is sleeved on the rotating shaft, and a first connection arm of the torsion spring is connected to the swing arm;
a stop part is disposed on the base, and when the swing arm is at the unfolding position, a second connection arm of the torsion spring is separated from the stop part for the torsion spring to be in a natural state; and
when the swing arm rotates between a middle position and the folding position, the second connection arm abuts against the stop part for the torsion spring to be in a force storage state, to apply, to the swing arm, the action force for driving the swing arm to rotate toward the unfolding position, wherein the middle position is a position between the folding position and the unfolding position in a rotation direction of the swing arm.

22. The hinge mechanism according to claim 21, wherein
an arc-shaped groove for the second connection arm to extend into is provided on the base, the arc-shaped groove extends in a circumferential direction of the rotating shaft, and a groove wall at an end of the arc-shaped groove is the stop part; or
the stop part is a stop surface disposed on the base, and motion space for the second connection arm to swing is provided between the stop surface and the torsion spring.

23. A terminal device, comprising a display, at least two housings, and the hinge mechanism according to any one of claims 1 to 22, wherein the housing is configured to carry the display, the hinge mechanism is located at a joint of two adjacent housings, and each swing arm of the swing arm assembly in the hinge mechanism is connected to a corresponding housing.
